# FASCICULE DE BREVET EUROPEEN

(11) **EP 3 053 195 B1**
(45) Date de publication et mention de la délivrance du brevet: **15.11.2017**
(21) Numéro de dépôt: 14789322.6
(22) Date de dépôt: 30.09.2014
(51) Int. Cl.: H01L 27/15

(54) **DISPOSITIF OPTOELECTRONIQUE A DIODES ELECTROLUMINESCENTES**
OPTOELEKTRONISCHE VORRICHTUNG MIT LEUCHTDIODEN
OPTOELECTRONIC DEVICE COMPRISING LIGHT-EMITTING DIODES

(30) Priorité: 30.09.2013 FR 1359409
(43) Date de publication de la demande: 10.08.2016
(73) Titulaire: Aledia, 38040 Grenoble (FR)
(72) Inventeur: BOUVIER, Christophe, F-38000 Grenoble (FR); DORNEL, Erwan, F-38600 Fontaine (FR)
(74) Mandataire: Thibon, Laurent
(86) Numéro de dépôt international: PCT/FR2014/052473
(87) Numéro de publication internationale: WO 2015/044621

(56) Documents cités:
- EP-A1- 2 357 676
- WO-A1-2011/048318

## Description

La présente demande de brevet revendique la priorité de la demande de brevet français FR13/59409.

### Domaine

La présente invention concerne de façon générale les dispositifs optoélectroniques à base de matériaux semiconducteurs et leurs procédés de fabrication. La présente invention concerne plus particulièrement les dispositifs optoélectroniques comprenant des diodes électroluminescentes formées par des éléments tridimensionnels, notamment des microfils ou nanofils semiconducteurs.

### Exposé de l'art antérieur

Par dispositifs optoélectroniques à diodes électroluminescentes, on entend des dispositifs adaptés à effectuer la conversion d'un signal électrique en un rayonnement électromagnétique, et notamment des dispositifs dédiés à l'émission d'un rayonnement électromagnétique, notamment de la lumière. Des exemples d'éléments tridimensionnels adaptés à la réalisation de diodes électroluminescentes sont des microfils ou nanofils comprenant un matériau semiconducteur à base d'un composé comportant majoritairement au moins un élément du groupe III et un élément du groupe V (par exemple du nitrure de gallium GaN), appelé par la suite composé III-V, ou comportant majoritairement au moins un élément du groupe II et un élément du groupe VI (par exemple de l'oxyde de zinc ZnO), appelé par la suite composé II-VI.

Les éléments tridimensionnels, notamment des microfils ou nanofils semiconducteurs, de plusieurs dispositifs optoélectroniques peuvent être formés sur un substrat qui est ensuite découpé pour délimiter des dispositifs optoélectroniques individuels. Chaque dispositif optoélectronique est alors disposé dans un boîtier, notamment pour protéger les éléments tridimensionnels, et le boîtier est fixé à un support, par exemple un circuit imprimé.

Le document EP2357676 A1 décrit un dispositif optoélectronique à diodes électroluminescentes filaires. Il peut être souhaitable de relier des diodes électroluminescentes en série. Dans ce but, les diodes électroluminescentes sont réalisées sur plusieurs dispositifs optoélectroniques distincts et ces dispositifs optoélectroniques sont fixés au support et connectés en série les uns aux autres. L'encombrement total du système optoélectronique obtenu peut être important. Le procédé de fabrication du système électronique comprenant les dispositifs optoélectroniques mis en série comprend alors, en plus des étapes de fabrication de chaque dispositif optoélectronique, des étapes distinctes de fixation des dispositifs optoélectroniques au support et des étapes de connexion des dispositifs optoélectroniques les uns aux autres. Ces étapes augmentent le coût de fabrication du système optoélectronique.

### Résumé

Ainsi, un objet d'un mode de réalisation est de pallier au moins en partie les inconvénients des dispositifs optoélectroniques à diodes électroluminescentes, notamment à microfils ou nanofils, décrits précédemment et de leurs procédés de fabrication.

Un autre objet d'un mode de réalisation est de réduire l'encombrement d'un système optoélectronique comprenant des diodes électroluminescentes montées en série.

Un autre objet d'un mode de réalisation est de réduire le nombre d'étapes du procédé de fabrication d'un système optoélectronique comprenant des diodes électroluminescentes montées en série.

Un autre objet d'un mode de réalisation est que les dispositifs optoélectroniques à diodes électroluminescentes puissent être fabriqués à une échelle industrielle et à bas coût.

Ainsi, un mode de réalisation prévoit un dispositif optoélectronique comprenant :
un substrat semiconducteur dopé d'un premier type de conductivité, le substrat comprenant des première et deuxième faces opposées ;
un premier ensemble de premières diodes électroluminescentes reposant sur une première portion du substrat et comprenant des premiers éléments semiconducteurs filaires, coniques ou tronconiques ;
une première électrode, au moins partiellement transparente, recouvrant chaque première diode électroluminescente ;
une première portion conductrice isolée du substrat et traversant le substrat depuis la deuxième face jusqu'à au moins la première face et reliée à la première électrode ;
un deuxième ensemble de deuxièmes diodes électroluminescentes reposant sur une deuxième portion du substrat et comprenant des deuxièmes éléments semiconducteurs filaires, coniques ou tronconiques ;
une deuxième électrode, au moins partiellement transparente, recouvrant chaque deuxième diode électroluminescente ;
une deuxième portion conductrice isolée du substrat et traversant le substrat depuis la deuxième face jusqu'à au moins la première face et reliée à la deuxième électrode ; et
un premier élément conducteur, reliant du côté de la deuxième face, la première portion conductrice à la deuxième portion de substrat.

Selon un mode de réalisation, la première portion de substrat est isolée de la deuxième portion de substrat par la première portion conductrice isolée.

Selon un mode de réalisation, le dispositif comprend des premier et deuxième bords latéraux opposés et la première portion conductrice isolée s'étend du premier bord au deuxième bord latéral.

Selon un mode de réalisation, la première portion conductrice isolée entoure la première portion de substrat.

Selon un mode de réalisation, le dispositif comprend une portion isolante, distincte de la première portion conductrice isolée et isolant la première portion de substrat de la deuxième portion de substrat.

Selon un mode de réalisation, le dispositif comprend des premier et deuxième bords latéraux opposés et la portion isolante s'étend du premier bord au deuxième bord latéral.

Selon un mode de réalisation, la première portion isolante entoure la première portion de substrat.

Selon un mode de réalisation, le dispositif comprend un premier plot conducteur sur la deuxième face au contact de la première portion de substrat.

Selon un mode de réalisation, le substrat est choisi parmi le groupe comprenant le silicium, le germanium, le carbure de silicium et les composés III-V.

Selon un mode de réalisation, la concentration de dopants du substrat est comprise entre 5*10¹⁶ et 2*10²⁰ atomes/cm³.

Selon un mode de réalisation, les diodes électroluminescentes du premier ensemble sont adaptées à émettre de la lumière à une première longueur d'onde et les diodes électroluminescentes du deuxième ensemble sont adaptées à émettre de la lumière à une seconde longueur d'onde différente de la première longueur d'onde.

Selon un mode de réalisation, le dispositif comprend, en outre :
un troisième ensemble de troisièmes diodes électroluminescentes reposant sur une troisième portion du substrat et comprenant des troisièmes éléments semiconducteurs filaires, coniques ou tronconiques ;
une troisième électrode, au moins partiellement transparente, recouvrant chaque troisième diode électroluminescente ;
une troisième portion conductrice isolée du substrat et traversant le substrat depuis la deuxième face jusqu'à au moins la première face et reliée à la troisième électrode ; et
un deuxième élément conducteur, reliant du côté de la deuxième face, la deuxième portion conductrice à la troisième portion de substrat.

Selon un mode de réalisation, les diodes électroluminescentes du troisième ensemble sont adaptées à émettre de la lumière à une troisième longueur d'onde différente des première et deuxième longueurs d'onde.

Selon un mode de réalisation, les surfaces des premier, deuxième et troisième ensembles sont choisies pour que la composition des lumières aux première, deuxième et troisième longueurs d'onde émises corresponde à une lumière émise blanche.

Selon un mode de réalisation, l'une de la première, deuxième ou troisième longueur d'onde correspond à une lumière bleue, une autre de la première, deuxième ou troisième longueur d'onde correspond à une lumière verte et une autre de la première, deuxième ou troisième longueur d'onde correspond à une lumière rouge.

Selon un mode de réalisation, le dispositif comprend de quatre à plus de cent ensembles de diodes électroluminescentes connectés en série par des portions conductrices isolées du substrat et traversant le substrat depuis la deuxième face jusqu'à au moins la première face.

Un mode de réalisation prévoit également un procédé de fabrication d'un dispositif optoélectronique comprenant les étapes suivantes :
(a) prévoir un substrat dopé d'un premier type de conductivité, le substrat comportant une première face ;
(b) former, sur la première face, un premier ensemble de premières diodes électroluminescentes reposant sur une première portion du substrat et comprenant des premiers éléments semiconducteurs filaires, coniques ou tronconiques et un deuxième ensemble de deuxièmes diodes électroluminescentes reposant sur une deuxième portion du substrat et comprenant des deuxièmes éléments semiconducteurs filaires, coniques ou tronconiques ;
(c) former une première électrode, au moins partiellement transparente, recouvrant chaque première diode électroluminescente et une deuxième électrode, au moins partiellement transparente, recouvrant chaque deuxième diode électroluminescente ;
(d) recouvrir la totalité de la première face d'une couche encapsulant les premières et deuxièmes diodes électroluminescentes ;
(e) réduire l'épaisseur du substrat ;
(f) former une première portion conductrice isolée du substrat et traversant le substrat depuis une deuxième face du substrat, opposée à la première face, jusqu'à au moins la première face et reliée à la première électrode et une deuxième portion conductrice isolée du substrat et traversant le substrat depuis la deuxième face jusqu'à au moins la première face et reliée à la deuxième électrode ; et
(g) former un élément conducteur, reliant du côté de la deuxième face, la première portion conductrice à la deuxième portion de substrat.

Selon un mode de réalisation, les étapes (a) à (g) sont successives.

Selon un mode de réalisation, l'étape (f) est réalisée avant l'étape (b).

Selon un mode de réalisation, l'étape (f) est réalisée entre les étapes (b) et (c).

Selon un mode de réalisation, l'étape (f) comprend successivement la gravure de premières ouvertures dans le substrat depuis la deuxième face, la formation d'une couche isolante au moins sur les parois latérales des premières ouvertures, et la formation d'une couche conductrice recouvrant la couche isolante, ou le remplissage des premières ouvertures par un matériau conducteur.

Selon un mode de réalisation, l'étape (f) comprend, avant l'étape (b) ou entre les étapes (b) et (c), la gravure de deuxièmes ouvertures dans le substrat depuis la première face sur une partie de l'épaisseur du substrat, les deuxièmes ouvertures étant ouvertes sur la deuxième face après l'étape d'amincissement du substrat.

Selon un mode de réalisation, la première électrode est, en outre, formée dans l'une des deuxièmes ouvertures et la deuxième électrode est, en outre, formée dans une autre des deuxièmes ouvertures.

Selon un mode de réalisation, le procédé comprend, avant l'étape (b), la formation d'une portion isolante au moins sur les parois latérales des deuxièmes ouvertures et le remplissage des deuxièmes ouvertures d'un matériau de remplissage.

Selon un mode de réalisation, le matériau de remplissage est identique au matériau composant le substrat.

Selon un mode de réalisation, le matériau de remplissage est un matériau semiconducteur dopé in situ.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe, partielle et schématique, d'un mode de réalisation d'un dispositif optoélectronique à microfils ou nanofils fabriqué sur un substrat semiconducteur ;
les figures 2 et 3 sont des vues de dessus, partielles et schématiques, illustrant deux agencements différents de tranchées conductrices du dispositif de la figure 1 ;
la figure 4 est une vue en coupe, partielle et schématique, d'un autre mode de réalisation d'un dispositif optoélectronique à microfils ou nanofils fabriqué sur un substrat semiconducteur ;
les figures 5 et 6 sont des vues de dessus, partielles et schématiques, illustrant deux agencements différents de tranchées isolantes du dispositif de la figure 3 ;
les figures 7 à 10 sont des vues en coupe, partielles et schématiques, d'autres modes de réalisation d'un dispositif optoélectronique à microfils ou nanofils fabriqué sur un substrat semiconducteur ;
les figures 11A à 11D sont des coupes, partielles et schématiques, de structures obtenues à des étapes successives d'un mode de réalisation d'un procédé de fabrication du dispositif optoélectronique à microfils ou nanofils représenté en figure 1 ;
les figures 12A à 12C sont des coupes, partielles et schématiques, de structures obtenues à des étapes successives d'un autre mode de réalisation d'un procédé de fabrication du dispositif optoélectronique à microfils ou nanofils représenté en figure 7 ;
les figures 13A et 13B sont des coupes, partielles et schématiques, de structures obtenues à des étapes successives d'un autre mode de réalisation d'un procédé de fabrication d'un dispositif optoélectronique à microfils ou nanofils ; et
les figures 14A à 14E sont des coupes, partielles et schématiques, de structures obtenues à des étapes successives d'un autre mode de réalisation d'un procédé de fabrication du dispositif optoélectronique à microfils ou nanofils représenté en figure 8.

### Description détaillée

Par souci de clarté, de mêmes éléments ont été désignés par de mêmes références aux différentes figures et, de plus, comme cela est habituel dans la représentation des circuits électroniques, les diverses figures ne sont pas tracées à l'échelle. En outre, seuls les éléments utiles à la compréhension de la présente description ont été représentés et sont décrits. En particulier, les moyens de commande des dispositifs optoélectroniques décrits ci-après sont à la portée de l'homme de l'art et ne sont pas décrits.

Dans la suite de la description, sauf indication contraire, les termes "sensiblement", "environ" et "de l'ordre de" signifient "à 10 % près". En outre, on entend par "composé principalement constitué d'un matériau" ou "composé à base d'un matériau" qu'un composé comporte une proportion supérieure ou égale à 95 % dudit matériau, cette proportion étant préférentiellement supérieure à 99 %.

La présente description concerne des dispositifs optoélectroniques à éléments tridimensionnels, par exemple des microfils, des nanofils, des éléments coniques ou des éléments tronconiques. Dans la suite de la description, des modes de réalisation sont décrits pour des dispositifs optoélectroniques à microfils ou à nanofils. Toutefois, ces modes de réalisation peuvent être mis en oeuvre pour des éléments tridimensionnels autres que des microfils ou des nanofils, par exemple des éléments tridimensionnels en forme de pyramide.

Le terme "microfil" ou "nanofil" désigne une structure tridimensionnelle de forme allongée selon une direction privilégiée dont au moins deux dimensions, appelées dimensions mineures, sont comprises entre 5 nm et 2,5 µm, de préférence entre 50 nm et 2,5 µm, la troisième dimension, appelée dimension majeure, étant au moins égale à 1 fois, de préférence au moins 5 fois et encore plus préférentiellement au moins 10 fois, la plus grande des dimensions mineures. Dans certains modes de réalisation, les dimensions mineures peuvent être inférieures ou égales à environ 1 µm, de préférence comprises entre 100 nm et 1 µm, plus préférentiellement entre 100 nm et 300 nm. Dans certains modes de réalisation, la hauteur de chaque microfil ou nanofil peut être supérieure ou égale à 500 nm, de préférence comprise entre 1 µm et 50 µm.

Dans la suite de la description, on utilise le terme "fil" pour signifier "microfil ou nanofil". De préférence, la ligne moyenne du fil qui passe par les barycentres des sections droites, dans des plans perpendiculaires à la direction privilégiée du fil, est sensiblement rectiligne et est appelée par la suite "axe" du fil.

Selon un mode de réalisation, il est prévu un dispositif optoélectronique comprenant au moins deux ensembles de diodes électroluminescentes, les diodes électroluminescentes de chaque ensemble étant montées en parallèle de sorte que l'ensemble de diodes électroluminescentes est équivalent à une diode électroluminescente globale. Les deux diodes électroluminescentes globales sont montées en série l'une avec l'autre. Pour réaliser ce montage en série, des connexions verticales traversantes ou TSV (acronyme anglais pour Through Silicon Via) sont réalisées dans le substrat semiconducteur sur lequel sont formées les diodes électroluminescentes.

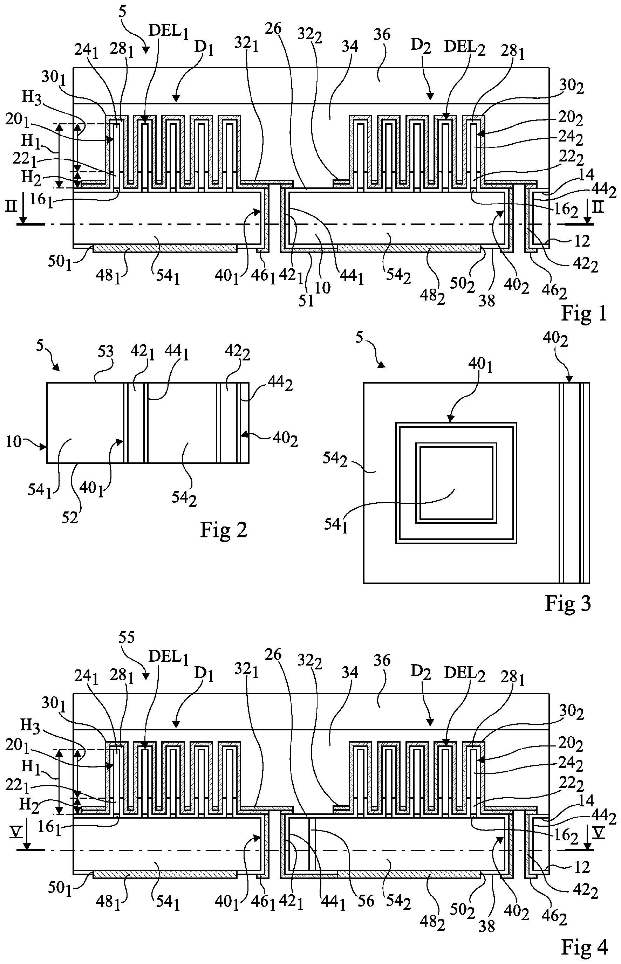

La figure 1 est une vue en coupe, partielle et schématique, d'un mode de réalisation d'un dispositif optoélectronique 5 à diodes électroluminescentes réalisées à partir de fils tels que décrits précédemment.

Le dispositif optoélectronique comprend deux ensembles D₁ et D₂ de diodes électroluminescentes. Dans la suite de la description, l'indice "1" ou "2" est ajouté à une référence pour désigner un élément associé respectivement à l'ensemble D₁ ou D₂.

En figure 1, on a représenté une structure comprenant :
- un substrat semiconducteur 10 comprenant une face inférieure 12 et une face supérieure 14 opposée, la face supérieure 14 étant de préférence plane au moins au niveau des diodes électroluminescentes ;
- des plots de germination 16₁, 16₂ favorisant la croissance de fils et disposés sur la face 14 ;
- des fils 20₁, 20₂ répartis en au moins deux ensembles D₁ et D₂ de fils (deux ensembles de cinq fils étant représentés à titre d'exemple) de hauteur H₁, chaque fil 20₁, 20₂ étant en contact avec l'un des plots de germination 16₁, 16₂, chaque fil 20₁, 20₂ comprenant une portion inférieure 22₁, 22₂, de hauteur H₂, en contact avec le plot de germination 16₁, 16₂ et une portion supérieure 24₁, 24₂, de hauteur H₃, prolongeant la portion inférieure 22₁, 22₂ ;
- une couche isolante 26 s'étendant sur la face 14 du substrat 10 et sur les flancs latéraux de la portion inférieure 22₁, 22₂ de chaque fil 20₁, 20₂ ;
- une coque 28₁, 28₂ comprenant un empilement de couches semiconductrices recouvrant chaque portion supérieure 24₁, 24₂ ;
- pour chaque ensemble D₁, D₂, une couche 30₁, 30₂ formant une électrode recouvrant chaque coque 28₁, 28₂ et s'étendant, en outre, sur la couche isolante 26 ;
- pour chaque ensemble D₁, D₂, une couche conductrice 32₁, 32₂ recouvrant la couche d'électrode 30₁, 30₂ entre les fils 20₁, 20₂ mais ne s'étendant pas sur les fils 20₁, 20₂ ;
- une couche d'encapsulation 34 recouvrant l'ensemble de la structure et notamment chaque couche d'électrode 30₁, 30₂ ;
- un support supplémentaire 36, également appelé poignée ;
- une couche isolante 38 recouvrant la face inférieure 12 ;
- pour chaque ensemble D₁, D₂, un TSV 40₁, 40₂, chaque TSV 40₁, 40₂ comprenant une portion conductrice 42₁, 42₂ qui est connectée à l'électrode 30₁, 30₂, qui s'étend dans le substrat 10 de la face supérieure 14 à la face inférieure 12 et qui est isolée du substrat 10 par une couche isolante 44₁, 44₂, la portion conductrice 42₁, 42₂ se prolongeant sur la couche isolante 38 par un plot conducteur 46₁, 46₂ ; et
- des plots conducteurs 48₁, 48₂ au contact de la face inférieure 12 au travers d'ouvertures 50₁, 50₂ prévues dans la couche isolante 38, chaque plot conducteur 48₁, 48₂ étant sensiblement disposé à l'aplomb des fils 20₁, 20₂ associés, le plot conducteur 48₂ étant relié au bord conducteur 46₁ par une portion conductrice 51.

Dans le mode de réalisation représenté en figure 1, chaque portion conductrice 42₁, 42₂ peut correspondre à une couche ou à un empilement de couches recouvrant la couche isolante 44₁, 44₂. Le coeur du TSV 40₁, 40₂ peut être rempli en totalité ou seulement partiellement d'un matériau conducteur.

Le dispositif optoélectronique 5 peut, en outre, comprendre une couche de luminophores, non représentée, confondue avec la couche d'encapsulation 34, ou prévue entre la couche d'encapsulation 34 et la poignée 36 ou prévue sur la poignée 36.

L'ensemble formé par chaque fil 20₁, 20₂, le plot de germination 16₁, 16₂ et la coque 28₁, 28₂ associés constitue une diode électroluminescente DEL₁, DEL₂. La base de la diode DEL₁, DEL₂ correspond au plot de germination 16₁, 16₂.

Les diodes électroluminescentes DEL₁ sont connectées en parallèle de sorte que l'ensemble D₁ de diodes électroluminescentes est équivalent à une diode électroluminescente globale. Les diodes électroluminescentes DEL₂ sont connectées en parallèle de sorte que l'ensemble D₂ de diodes électroluminescentes est équivalent à une diode électroluminescente globale. Chaque ensemble D₁ et D₂ peut comprendre de quelques diodes électroluminescentes DEL₁, DEL₂ à un millier de diodes électroluminescentes.

Dans le présent mode de réalisation, le substrat semiconducteur 10 correspond à une structure monolithique. Le substrat 10 semiconducteur est, par exemple, un substrat en silicium, en germanium, en carbure de silicium, en un composé III-V, tel que du GaN ou du GaAs, ou un substrat en ZnO. De préférence, le substrat 10 est un substrat de silicium monocristallin.

De préférence, le substrat semiconducteur 10 est dopé de façon à baisser la résistivité électrique jusqu'à une résistivité proche de celle des métaux, de préférence inférieure à quelques mohm.cm. Le substrat 10 est de préférence un substrat fortement dopé avec une concentration de dopants comprise entre 5*10¹⁶ atomes/cm³ et 2*10²⁰ atomes/cm³, de préférence entre 1*10¹⁹ atomes/cm³ et 2*10²⁰ atomes/cm³, par exemple 5*10¹⁹ atomes/cm³. Le substrat 10 a une épaisseur comprise entre 275 µm et 1500 µm, de préférence 725 µm. Dans le cas d'un substrat 10 de silicium, des exemples de dopants de type P sont le bore (B) ou l'indium (In) et des exemples de dopants de type N sont le phosphore (P), l'arsenic (As), ou l'antimoine (Sb). De préférence, le substrat 10 est dopé de type N au Phosphore. La face 12 du substrat 10 de silicium peut être une face (100).

Les plots de germination 16₁, 16₂, appelés également îlots de germination, sont en un matériau favorisant la croissance des fils 20₁, 20₂. Un traitement peut être prévu pour protéger les flancs latéraux des plots de germination et la surface des parties du substrat non recouvertes par les plots de germination pour empêcher la croissance des fils sur les flancs latéraux des plots de germination et sur la surface des parties du substrat non recouvertes par les plots de germination. Le traitement peut comprendre la formation d'une région diélectrique sur les flancs latéraux des plots de germination et s'étendant sur et/ou dans le substrat et reliant, pour chaque paire de plots, l'un des plots de la paire à l'autre plot de la paire, les fils ne croissant pas sur la région diélectrique. Ladite région diélectrique peut déborder au-dessus des plots de germination 16₁, 16₂. A titre de variante, les plots de germination 16₁, 16₂ peuvent être remplacés par une couche de germination recouvrant la face 14 du substrat 10 dans la zone associée à l'ensemble D₁ ou D₂. Une région diélectrique peut alors être formée au-dessus de la couche de germination pour empêcher la croissance de fils dans les emplacements non voulus.

A titre d'exemple, le matériau composant les plots de germination 16₁, 16₂ peut être un nitrure, un carbure ou un borure d'un métal de transition de la colonne IV, V ou VI du tableau périodique des éléments ou une combinaison de ces composés. A titre d'exemple, les plots de germination 16₁, 16₂ peuvent être en nitrure d'aluminium (AIN), en bore (B), en nitrure de bore (BN), en titane (Ti), en nitrure de titane (TiN), en tantale (Ta), en nitrure de tantale (TaN), en hafnium (Hf), en nitrure d'hafnium (HfN), en niobium (Nb), en nitrure de niobium (NbN), en zirconium (Zr), en borate de zirconium (ZrB₂), en nitrure de zirconium (ZrN), en carbure de silicium (SiC), en nitrure et carbure de tantale (TaCN), en nitrure de magnésium sous la forme MgₓN_{y}, où x est environ égal à 3 et y est environ égal à 2, par exemple du nitrure de magnésium selon la forme Mg₃N₂ ou du nitrure de gallium et de magnésium (MgGaN), en tungstène (W), en nitrure de tungstène (WN) ou en une combinaison de ceux-ci.

Les plots de germination 16₁, 16₂ peuvent être dopés du même type de conductivité que le substrat 10.

La couche isolante 26 peut être en un matériau diélectrique, par exemple en oxyde de silicium (SiO₂), en nitrure de silicium (SiₓN_{y}, où x est environ égal à 3 et y est environ égal à 4, par exemple du Si₃N₄), en oxynitrure de silicium (SiOₓN_{y} où x peut être environ égal à 1/2 et y peut être environ égal à 1, par exemple du Si₂ON₂), en oxyde d'aluminium (Al₂O₃), en oxyde d'hafnium (HfO₂) ou en diamant. A titre d'exemple, l'épaisseur de la couche isolante 26 est comprise entre 5 nm et 800 nm, par exemple égale à environ 30 nm.

Les fils 20₁, 20₂ sont, au moins en partie, formés à partir d'au moins un matériau semiconducteur. Le matériau semiconducteur peut être du silicium, du germanium, du carbure de silicium, un composé III-V, un composé II-VI ou une combinaison de ces composés.

Les fils 20₁, 20₂ peuvent être, au moins en partie, formés à partir de matériaux semiconducteurs comportant majoritairement un composé III-V, par exemple des composés III-N. Des exemples d'éléments du groupe III comprennent le gallium (Ga), l'indium (In) ou l'aluminium (Al). Des exemples de composés III-N sont GaN, AlN, InN, InGaN, AlGaN ou AlInGaN. D'autres éléments du groupe V peuvent également être utilisés, par exemple, le phosphore ou l'arsenic. De façon générale, les éléments dans le composé III-V peuvent être combinés avec différentes fractions molaires.

Les fils 20₁, 20₂ peuvent être, au moins en partie, formés à partir de matériaux semiconducteurs comportant majoritairement un composé II-VI. Des exemples d'éléments du groupe II comprennent des éléments du groupe IIA, notamment le béryllium (Be) et le magnésium (Mg) et des éléments du groupe IIB, notamment le zinc (Zn) et le cadmium (Cd). Des exemples d'éléments du groupe VI comprennent des éléments du groupe VIA, notamment l'oxygène (O) et le tellure (Te). Des exemples de composés II-VI sont ZnO, ZnMgO, CdZnO ou CdZnMgO. De façon générale, les éléments dans le composé II-VI peuvent être combinés avec différentes fractions molaires.

Les fils 20₁, 20₂ peuvent comprendre un dopant. A titre d'exemple, pour des composés III-V, le dopant peut être choisi parmi le groupe comprenant un dopant de type P du groupe II, par exemple, du magnésium (Mg), du zinc (Zn), du cadmium (Cd) ou du mercure (Hg), un dopant du type P du groupe IV, par exemple du carbone (C) ou un dopant de type N du groupe IV, par exemple du silicium (Si), du germanium (Ge), du sélénium (Se), du souffre (S), du terbium (Tb) ou de l'étain (Sn).

La section droite des fils 20₁, 20₂ peut avoir différentes formes, telles que, par exemple, une forme ovale, circulaire ou polygonale, notamment triangulaire, rectangulaire, carrée ou hexagonale. Ainsi, on comprend que, quand on mentionne ici le "diamètre" dans une section droite d'un fil ou d'une couche déposée sur ce fil, il s'agit d'une grandeur associée à la surface de la structure visée dans cette section droite, correspondant, par exemple, au diamètre du disque ayant la même surface que la section droite du fil. Le diamètre moyen de chaque fil 20₁, 20₂ peut être compris entre 50 nm et 2,5 µm. La hauteur H₁ de chaque fil 20₁, 20₂ peut être comprise entre 250 nm et 50 µm. Chaque fil 20₁, 20₂ peut avoir une structure semiconductrice allongée selon un axe sensiblement perpendiculaire à la face 14. Chaque fil 20₁, 20₂ peut avoir une forme générale cylindrique. Les axes de deux fils 20 adjacents peuvent être distants de 0,5 µm à 10 µm et de préférence de 1,5 µm à 4 µm. A titre d'exemple, les fils 20₁, 20₂ peuvent être régulièrement répartis, notamment selon un réseau hexagonal.

A titre d'exemple, la portion inférieure 22₁, 22₂ de chaque fil 20₁, 20₂ est principalement constituée du composé III-N, par exemple du nitrure de gallium, dopé du même type que le substrat 10, par exemple de type N, par exemple au silicium. La portion inférieure 22₁, 22₂ s'étend sur une hauteur H₂ qui peut être comprise entre 100 nm et 25 µm.

A titre d'exemple, la portion supérieure 24₁, 24₂ de chaque fil 20₁, 20₂ est au moins partiellement réalisée dans un composé III-N, par exemple du GaN. La portion supérieure 24₁, 24₂ peut être dopée de type N, éventuellement moins fortement dopée que la portion inférieure 22₁, 22₂, ou ne pas être intentionnellement dopée. La portion supérieure 24₁, 24₂ s'étend sur une hauteur H₃ qui peut être comprise entre 100 nm et 25 µm.

La coque 28₁, 28₂ peut comprendre un empilement de plusieurs couches comprenant notamment :
- une couche active recouvrant la portion supérieure 24₁, 24₂ du fil 20₁, 20₂ associé ;
- une couche intermédiaire de type de conductivité opposé à la portion inférieure 22₁, 22₂ recouvrant la couche active ; et
- une couche de liaison recouvrant la couche intermédiaire et recouverte par l'électrode 30₁, 30₂.

La couche active est la couche depuis laquelle est émise la majorité du rayonnement fourni par la diode électroluminescente DEL₁, DEL₂. Selon un exemple, la couche active peut comporter des moyens de confinement, tels que des puits quantiques multiples. Elle est, par exemple, constituée d'une alternance de couches de GaN et de InGaN ayant des épaisseurs respectives de 5 à 20 nm (par exemple 8 nm) et de 1 à 10 nm (par exemple 2,5 nm). Les couches de GaN peuvent être dopées, par exemple de type N ou P. Selon un autre exemple, la couche active peut comprendre une seule couche d'InGaN, par exemple d'épaisseur supérieure à 10 nm.

La couche intermédiaire, par exemple dopée de type P, peut correspondre à une couche semiconductrice ou à un empilement de couches semiconductrices et permet la formation d'une jonction P-N ou P-I-N, la couche active étant comprise entre la couche intermédiaire de type P et la portion supérieure 24₁, 24₂ de type N de la jonction P-N ou P-I-N.

La couche de liaison peut correspondre à une couche semiconductrice ou à un empilement de couches semiconductrices et permet la formation d'un contact ohmique entre la couche intermédiaire et l'électrode 30₁, 30₂. A titre d'exemple, la couche de liaison peut être dopée très fortement du type opposé à la portion inférieure 22₁, 22₂ de chaque fil 20, jusqu'à dégénérer la ou les couches semiconductrices, par exemple dopée de type P à une concentration supérieure ou égale à 10²⁰ atomes/cm³.

L'empilement de couches semiconductrices peut comprendre une couche de blocage d'électrons formée d'un alliage ternaire, par exemple en nitrure de gallium et d'aluminium (AlGaN) ou en nitrure d'indium et d'aluminium (AlInN) en contact avec la couche active et la couche intermédiaire, pour assurer une bonne répartition des porteurs électriques dans la couche active.

L'électrode 30₁, 30₂ est adaptée à polariser la couche active de chaque fil 20₁, 20₂ et à laisser passer le rayonnement électromagnétique émis par les diodes électroluminescentes DEL₁, DEL₂. Le matériau formant l'électrode 30₁, 30₂ peut être un matériau transparent et conducteur tel que de l'oxyde d'indium-étain (ou ITO, acronyme anglais pour Indium Tin Oxide), de l'oxyde de zinc dopé à l'aluminium ou du graphène. A titre d'exemple, la couche d'électrode 30₁, 30₂ a une épaisseur comprise entre 5 nm et 200 nm, de préférence entre 20 nm et 50 nm.

La couche conductrice 32₁, 32₂ correspond, de préférence à une couche métallique, par exemple en aluminium, en argent, en cuivre ou en zinc. A titre d'exemple, la couche conductrice 32₁, 32₂ a une épaisseur comprise entre 20 nm et 1000 nm, de préférence entre 100 nm et 200 nm.

La couche d'encapsulation 34 est réalisée en un matériau isolant au moins partiellement transparent. L'épaisseur minimale de la couche d'encapsulation 34 est comprise entre 250 nm et 50 µm de sorte que la couche d'encapsulation 34 recouvre complètement chaque électrode 30₁, 30₂ au sommet des diodes électroluminescentes DEL₁, DEL₂. La couche d'encapsulation 34 peut être réalisée en un matériau inorganique au moins partiellement transparent. A titre d'exemple, le matériau inorganique est choisi parmi le groupe comprenant les oxydes de silicium du type SiOₓ où x est un nombre réel compris entre 1 et 2 ou SiO_{y}N_{z} où y et z sont des nombres réels compris entre 0 et 1 et les oxydes d'aluminium, par exemple Al₂O₃. La couche d'encapsulation 34 peut être réalisée en un matériau organique au moins partiellement transparent. A titre d'exemple, la couche d'encapsulation 34 est un polymère silicone, un polymère époxyde, un polymère acrylique ou un polycarbonate.

A titre d'exemple, la poignée 36 a une épaisseur comprise entre 200 µm et 1000 µm. La poignée 36 est en un matériau au moins en partie transparent. Il peut s'agir de verre, notamment un verre borosilicate, par exemple du pyrex, ou de saphir.

Selon un autre mode de réalisation, la poignée 36 n'est pas présente.

La polarisation des diodes électroluminescentes globales D₁ et D₂ est obtenue en reliant le plot conducteur 48₁ à une source d'un premier potentiel de référence et en reliant le plot conducteur 46₂ à une source d'un deuxième potentiel de référence. A titre d'exemple, dans le cas de fil dopé de type N, le premier potentiel (cathode) peut être inférieur au deuxième potentiel (anode) et la source du premier potentiel peut correspondre à la masse. Cette différence de potentiels est de préférence supérieure à la somme des tensions de seuil de chaque diode électroluminescente globale afin de polariser l'ensemble des deux diodes électroluminescentes globales en série en direct pour permettre le passage du courant. A titre d'exemple, la différence de potentiels peut être de l'ordre de 6 V pour deux diodes GaN en série.

Une couche de passivation, notamment en polymère, peut être déposée sur la structure du côté de la face arrière, des ouvertures étant formées dans la couche de passivation pour exposer les plots conducteurs 48₁ et 46₂. Les plots conducteurs 48₁ et 46₂ servent à l'assemblage du composant optoélectronique encapsulé sur son support final, par exemple un circuit imprimé. Les méthodes d'assemblage peuvent comprendre des opérations de brasage. L'empilement métallique est choisi de telle manière à être compatible avec les opérations de brasage utilisées dans l'industrie de l'électronique et notamment avec la brasure utilisée, par exemple en Cu avec finition OSP (acronyme anglais pour Organic Solderability Preservative) ou finition Ni-Au (par voie chimique (ENIG, acronyme anglais pour Electroless nickel immersion gold) ou électrochimique), Sn, Sn-Ag, Ni-Pd-Au, Sn-Ag-Cu, Ti-Wn-Au ou ENEPIG (acronyme anglais pour Electroless Nickel/ Electroless Palladium/ Immersion Gold).

Le dispositif optoélectronique 5 comprend, en outre, des moyens d'isolation électrique entre la portion du substrat 10 qui s'étend entre le plot conducteur 48₁ et les diodes électroluminescentes DEL₁ et la portion du substrat 10 qui s'étend entre le plot conducteur 48₂ et les diodes électroluminescentes DEL₂. Selon un mode de réalisation, cette isolation électrique est réalisée par le TSV 40₁.

La couche active de la coque 28₁ peut être fabriquée de manière identique ou non à la couche active de la coque 28₂. Par exemple, la couche active de la coque 28₁ peut être adaptée pour émettre une lumière à une première longueur d'onde, par exemple une lumière bleue et la couche active de la coque 28₂ peut être adaptée pour émettre une lumière à une deuxième longueur d'onde différente de la première longueur d'onde, par exemple une lumière verte. Ceci peut être obtenu, par exemple, en adaptant les épaisseurs ou les compositions des puits quantiques composants ces couches actives. Dans le cas où les couches actives des coques 28₁ et 28₂ sont fabriquées de manières différentes, une première étape de masquage peut être prévue pour protéger la diode électroluminescente globale D₂ pendant la réalisation de la couche active de la coque 28₁ et une seconde étape de masquage peut être prévue pour protéger la diode électroluminescente globale D₁ pendant la réalisation de la partie active de la coque 28₂.

A titre d'exemple, le dispositif optoélectronique 5 peut comporter une troisième diode électroluminescente globale connectée en série aux diodes électroluminescentes globales D₁ et D₂. A titre d'exemple, cette troisième diode électroluminescente globale peut être adaptée pour émettre une lumière à une troisième longueur d'onde différente des première et deuxième longueurs d'onde, par exemple une lumière rouge. Ainsi la composition des lumières bleue, verte, et rouge peut être choisie pour qu'un observateur perçoive une lumière blanche par composition des couleurs.

La figure 2 est une coupe à une échelle réduite, partielle et schématique, du dispositif optoélectronique 5 de la figure 1 selon la ligne II-II. Selon un mode de réalisation, le dispositif optoélectronique 5 comprend deux bords latéraux opposés 52, 53 et le TSV 40₁ s'étend sur la totalité de la largeur du substrat 10, du bord latéral 52 au bord latéral 53, de façon à diviser le substrat 10 en deux portions de substrat 54₁ et 54₂. Le TSV 40₁ isole électriquement la portion de substrat 54₁ de la portion de substrat 54₂. Le TSV 40₁ correspond alors à une tranchée qui s'étend du bord latéral 52 au bord latéral 53 sur une distance qui dépend de la taille du composant optoélectronique 5, par exemple comprise entre 15 µm et 3000 µm, par exemple environ 350 µm. La largeur du TSV 40₁, c'est-à-dire la distance séparant les deux parois latérales du TSV 40₁ est comprise entre 5 et 200 µm, par exemple 50 µm. Le TSV 40₂ s'étend le long ou à proximité d'un bord latéral de la portion de substrat 54₂ opposé au TSV 40₁. La longueur de la portion de substrat 54₁, c'est-à-dire la distance séparant le TSV 40₁ du bord latéral de la portion de substrat 54₂ opposé au TSV 40₁ peut être identique ou différente de la longueur de la portion de substrat 54₂, c'est-à-dire la distance séparant le TSV 40₁ du TSV 40₂. Par exemple, dans le cas où les couches actives des coques 28₁ et 28₂ sont fabriquées pour avoir des émissions de lumière de couleurs différentes, les longueurs des portions de substrat 54₁ et 54₂ peuvent être adaptées pour obtenir des surfaces de diodes électroluminescentes globales permettant d'obtenir une composition voulue des couleurs. A titre d'exemple, dans le cas de trois diodes électroluminescentes globales émettant des lumières bleue, verte et rouge, lesdites surfaces peuvent être choisies de manière à obtenir une couleur blanche par composition des couleurs.

La figure 3 est une coupe analogue à la figure 2 d'un autre mode de réalisation dans lequel le TSV 40₁ suit, dans le plan de coupe, une courbe fermée, par exemple carrée comme cela est représenté en figure 3, rectangulaire, circulaire, elliptique, etc. Le TSV 40₁ entoure la portion de substrat 54₁ et est entouré par la portion de substrat 54₂. Le TSV 40₂ peut s'étendre le long d'un bord latéral de la portion de substrat 54₂. Le TSV 40₂ peut également suivre, dans le plan de coupe, une courbe fermée, par exemple carrée, rectangulaire, circulaire, elliptique, etc, de manière concentrique au TSV 40₁.

A titre d'exemple, le dispositif optoélectronique 5 peut comprendre plus de deux diodes électroluminescentes globales en série. Dans ce cas, chaque TSV séparant une paire de diodes électroluminescentes globales adjacentes de la succession de diodes électroluminescentes globales peut suivre une courbe fermée concentrique au TSV séparant la paire précédente de diodes électroluminescentes globales adjacentes de la succession de diodes électroluminescentes globales. Le dispositif optoélectronique 5 peut, par exemple, comprendre trois diodes électroluminescentes globales dont le premier TSV forme une courbe fermée, le deuxième TSV forme une courbe fermée concentrique au premier TSV et le troisième TSV s'étend le long du bord latéral. A titre d'exemple, dans le cas de trois diodes électroluminescentes globales émettant des lumières bleue, verte et rouge, lesdites surfaces peuvent être choisies de manière à obtenir une couleur blanche par composition des couleurs.

Selon un autre mode de réalisation, l'isolation électrique entre les portions de substrat 54₁ et 54₂ peut être réalisée par d'autres moyens que les TSV 40₁, 40₂. Il peut s'agir de tranchées remplies d'un matériau isolant s'étendant sur toute la profondeur du substrat 10 ou de régions dopées d'un type de polarité opposé au substrat 10 et s'étendant sur toute la profondeur du substrat 10.

La figure 4 est une vue en coupe analogue à la figure 1 d'un autre mode de réalisation d'un dispositif optoélectronique 55. Le dispositif optoélectronique 55 comprend l'ensemble des éléments du dispositif optoélectronique 5 représenté en figure 1 et comprend, en outre, au moins une tranchée d'isolation 56 s'étendant sur toute l'épaisseur du substrat 10 de la face supérieure 14 à la face inférieure 12. Il peut s'agir d'une tranchée 56 réalisée par un procédé de fabrication de tranchée d'isolation profonde (en anglais Deep Trench Isolation).

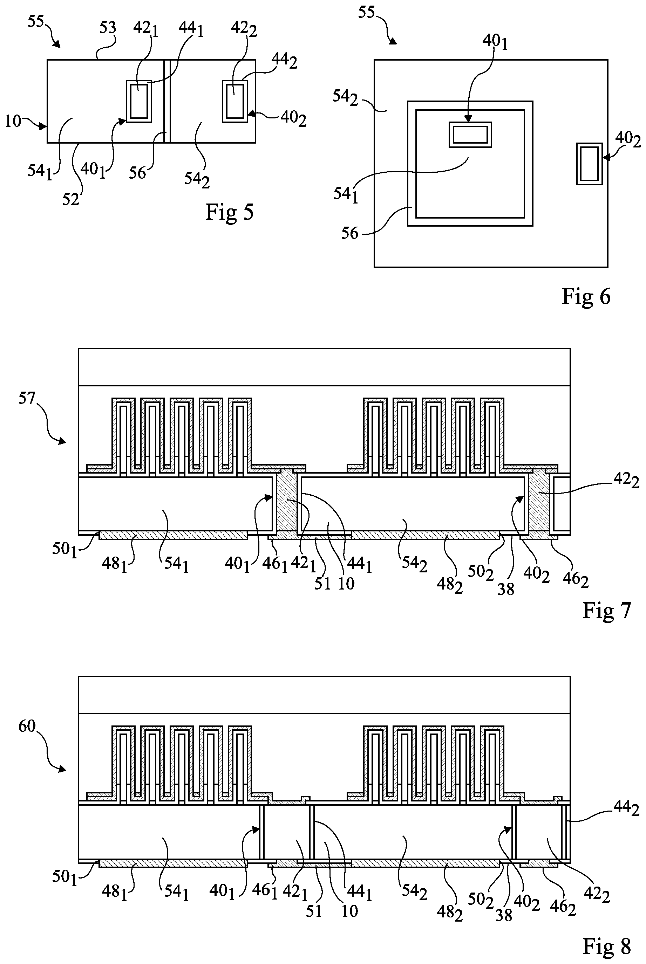

La figure 5 est une coupe à une échelle réduite, partielle et schématique, du dispositif optoélectronique 55 de la figure 4 selon la ligne V-V. La tranchée d'isolation 56 s'étend sur la totalité de la largeur du substrat 10, du bord latéral 52 au bord latéral 53 et isole électriquement la portion de substrat 54₁ de la portion de substrat 54₂. La tranchée d'isolation 56 s'étend du bord latéral 52 au bord latéral 53 sur une distance qui dépend de la taille du composant optoélectronique 55, par exemple comprise entre 15 µm et 3000 µm, par exemple environ 350 µm. La largeur de la tranchée d'isolation 56, c'est-à-dire la distance séparant les deux parois latérales de la tranchée d'isolation est comprise entre 1 et 10 µm, par exemple 2 µm.

Les dimensions de chaque TSV 40₁, 40₂ sont adaptées aux dimensions du dispositif optoélectronique. Pour chaque diode électroluminescente globale D₁, D₂, plusieurs TSV 40₁, 40₂, 100₁, 100₂ peuvent être réalisés simultanément afin de créer des connexions en parallèle. Cela permet de réduire la résistance des connexions. Ces connexions peuvent être disposées à la périphérie de la zone où sont formées les diodes électroluminescentes DEL dans une zone sans fil.

La figure 6 est une coupe analogue à la figure 5 d'un autre mode de réalisation dans lequel la tranchée d'isolation 56 suit, dans le plan de coupe, une courbe fermée, par exemple carrée comme cela est représenté en figure 6, rectangulaire, circulaire, elliptique, etc. La tranchée d'isolation 56 entoure la portion de substrat 54₁ et est entourée par la portion de substrat 54₂.

La figure 7 est une vue analogue à la figure 1 d'un autre mode de réalisation d'un dispositif optoélectronique 57. Le dispositif optoélectronique 57 comprend l'ensemble des éléments du dispositif optoélectronique 5 représenté en figure 1 à la différence que la portion conductrice 42₁, 42₂ remplit en totalité chaque TSV 40₁, 40₂.

La figure 8 est une vue analogue à la figure 7 d'un autre mode de réalisation d'un dispositif optoélectronique 60. Le dispositif optoélectronique 60 comprend l'ensemble des éléments du dispositif optoélectronique 5 représenté en figure 1 à la différence que la portion conductrice 42₁, 42₂ de chaque TSV 40₁, 40₂ correspond à une portion du substrat 10 qui est isolée du reste du substrat par la couche isolante 44₁, 44₂.

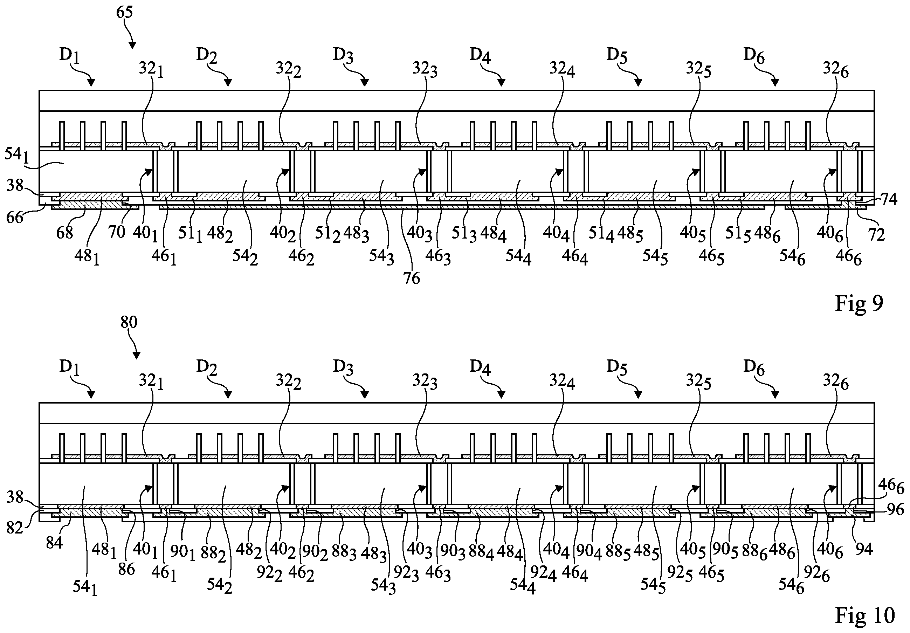

La figure 9 est une vue en coupe, partielle et schématique, d'un mode de réalisation d'un dispositif optoélectronique 65 comprenant une succession de plusieurs diodes électroluminescentes globales connectées en série. A titre exemple, six diodes électroluminescentes globales D₁ à D₆ sont représentées en figure 9. Dans la suite de la description, l'indice "1", "2" ... ou "6" est ajouté à une référence pour désigner un élément associé respectivement à la diode électroluminescente globale D₁, D₂ ... ou D₆. En figure 9, les diodes électroluminescentes ne sont pas représentées en détail. En particulier, l'électrode recouvrant les diodes électroluminescentes n'est pas représentée et seule la couche conductrice 32i est représentée. Le dispositif optoélectronique 65 peut comprendre de 2 à plus de 100 ensembles de diodes électroluminescentes disposés en série. L'association d'ensembles de diodes électroluminescentes montés en série permet d'augmenter l'amplitude maximale de la tension d'alimentation appliquée aux ensembles de diodes électroluminescentes qui est égale à la différence entre les premier et deuxième potentiels de référence. A titre d'exemple, la tension d'alimentation peut avoir une amplitude maximale supérieure ou égale à 6 V, par exemple d'environ 12 V, 24 V, 48 V, 110 V ou 240 V.

Le dispositif optoélectronique est obtenu en reproduisant plusieurs fois la structure représentée sur l'une des figures 1, 7 ou 8. A l'exception des diodes électroluminescentes globales situées aux extrémités de la succession, l'anode de chaque diode électroluminescente globale considérée est connectée à la cathode de la diode électroluminescente globale de la succession qui suit la diode électroluminescente globale considérée et la cathode de la diode électroluminescente globale considérée est connectée à l'anode de la diode électroluminescente globale de la succession qui précède la diode électroluminescente globale considérée. Dans ce but, le plot conducteur 48ᵢ de chaque diode électroluminescente globale Dᵢ, pour i compris entre 2 et 6, est connecté au plot conducteur 46ᵢ₋₁ de la diode électroluminescente globale Dᵢ₋₁ par la piste conductrice 51ᵢ₋₁ qui s'étend sur la couche conductrice 38. En outre, le TSV 40ᵢ est relié à la couche conductrice 32ᵢ de la diode électroluminescente globale Dᵢ. Les TSV 40ᵢ et 40ᵢ₊₁ délimitent la portion de substrat 54ᵢ₊₁.

Par rapport aux structures représentées sur l'une des figures 1, 7 ou 8, le dispositif optoélectronique 65 comprend, en outre :
- une couche isolante 66 recouvrant la couche isolante 38, recouvrant en totalité les plots conducteurs 46ᵢ et 48ᵢ des diodes électroluminescentes Dᵢ, où i est compris entre 2 et 5, le TSV 40₁ et le plot conducteur 48₆, et recouvrant partiellement le plot conducteur 48₁ et le plot conducteur 46₆ ;
- un plot conducteur 68 au contact du plot conducteur 48₁ au travers d'une ouverture 70 prévue dans la couche isolante 66 ;
- un plot conducteur 72 au contact du plot conducteur 46₆ au travers d'une ouverture 74 prévue dans la couche isolante 66 ; et
- un plot conducteur 76 s'étendant sur la couche isolante 66 en vis-à-vis des diodes électroluminescentes globales D₂ à D₅ et jouant le rôle d'un plot thermique.

La figure 10 est une vue analogue à la figure 9 d'un autre mode de réalisation d'un dispositif optoélectronique 80 comprenant une succession de plusieurs diodes électroluminescentes globales connectées en série D₁ à D₆. Le dispositif optoélectronique 80 est obtenu en reproduisant plusieurs fois la structure représentée sur l'une des figures 1, 7 ou 8 à la différence que la portion conductrice 51 n'est pas présente. Par rapport aux structures représentées sur l'une des figures 1, 7 ou 8, le dispositif optoélectronique 80 comprend, en outre :
- une couche isolante 82 supplémentaire recouvrant la couche isolante 38 ;
- un plot conducteur 84 au contact du plot conducteur 48₁ au travers d'une ouverture 86 prévue dans la couche isolante 82 ;
- des plots conducteurs 88ᵢ, i variant de 2 à 5, chaque plot conducteur 88ᵢ étant au contact du plot conducteur 46ᵢ₋₁ au travers d'une ouverture 90ᵢ₋₁ prévue dans la couche isolante 82 et au contact du plot conducteur 48ᵢ au travers d'une ouverture 92i prévue dans la couche isolante 82 ;
- un plot conducteur 94 au contact du plot conducteur 46₆ au travers d'une ouverture 96 prévue dans la couche isolante 82 ; et
- une couche isolante 98 recouvrant la couche isolante 82, recouvrant en totalité les plots conducteurs 88ᵢ, où i est compris entre 2 et 5, et recouvrant partiellement les plots conducteurs 84 et 94.

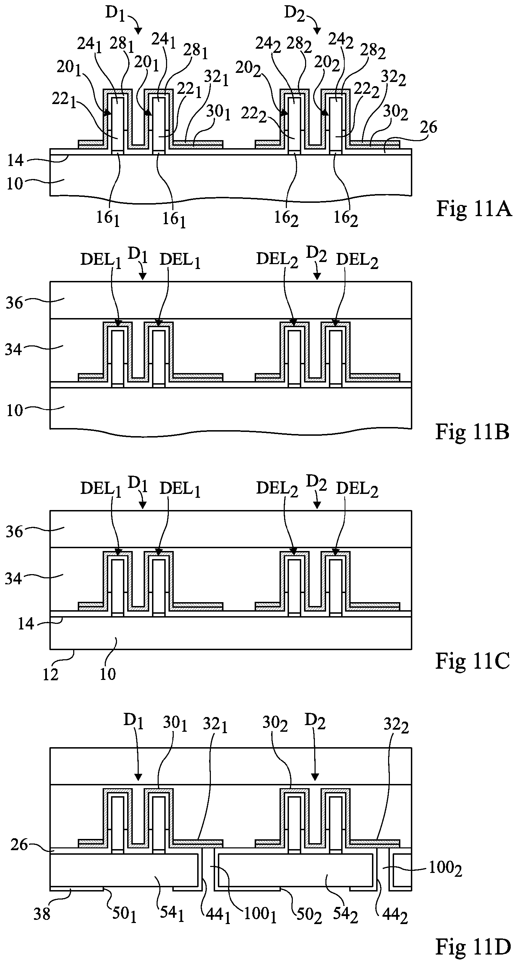

Les figures 11A à 11D sont des coupes, partielles et schématiques, de structures obtenues à des étapes successives d'un mode de réalisation d'un procédé de fabrication du dispositif optoélectronique 5 représenté en figure 1, seuls deux fils étant représentés pour chaque diode électroluminescente globale.

Un mode de réalisation d'un procédé de fabrication permettant l'obtention de la structure représentée en figure 11A comprend les étapes suivantes :
(1) Formation sur la face 14 du substrat 10 des plots de germination 16₁, 16₂.
   Les plots de germination 16 peuvent être obtenus par le dépôt d'une couche de germination sur la face 14 et par la gravure de portions de la couche de germination jusqu'à la face 12 du substrat 10 pour délimiter les plots de germination. La couche de germination peut être déposée par un procédé du type dépôt chimique en phase vapeur (CVD, sigle anglais pour Chemical Vapor Deposition) ou dépôt chimique en phase vapeur organométallique (MOCVD, acronyme anglais pour Metal-Organic Chemical Vapor Deposition), également connu sous le nom d'épitaxie organométallique en phase vapeur (ou MOVPE, acronyme anglais pour Metal-Organic Vapor Phase Epitaxy). Toutefois, des procédés tels que l'épitaxie par jets moléculaires (MBE, acronyme anglais pour Molecular-Beam Epitaxy), la MBE à source de gaz (GSMBE), la MBE organométallique (MOMBE), la MBE assistée par plasma (PAMBE), l'épitaxie par couche atomique (ALE, acronyme anglais pour Atomic Layer Epitaxy), l'épitaxie en phase vapeur aux hydrures (HVPE, acronyme anglais pour Hydride Vapor Phase Epitaxy) peuvent être utilisés ou un procédé de dépôt de couche mince atomique (ALD, acronyme anglais pour Atomic Layer Deposition). En outre, des procédés tels l'évaporation ou la pulvérisation cathodique réactive peuvent être utilisés.
   Lorsque les plots de germination 16₁, 16₂ sont en nitrure d'aluminium, ils peuvent être sensiblement texturés et posséder une polarité préférentielle. La texturation des plots 16₁, 16₂ peut être obtenue par un traitement supplémentaire réalisé après le dépôt de la couche de germination. Il s'agit, par exemple, d'un recuit sous flux d'ammoniac (NH₃).
(2) Protection des portions de la face 14 du substrat 10 non recouvertes des plots de germination 16₁, 16₂ pour éviter la croissance ultérieure de fils sur ces portions. Ceci peut être obtenu par une étape de nitruration qui entraîne la formation, en surface du substrat 10, entre les plots de germination 16₁, 16₂ de régions de nitrure de silicium (par exemple SiN ou Si₃N₄). Ceci peut également être obtenu par une étape de masquage du substrat 10 entre les plots de germination 16₁, 16₂, incluant le dépôt d'une couche par exemple d'un diélectrique SiO₂ ou SiN ou Si₃N₄ puis la gravure de cette couche hors des plots de germination 16₁, 16₂ après une étape de photolithographie. Dans ce cas, la couche de masquage peut déborder au-dessus des plots de germination 16₁, 16₂. Lorsque l'étape de protection (2) est réalisée par une étape de masquage du substrat 10, l'étape de gravure de la couche de germination peut être évitée. Les plots de germination 16₁, 16₂ sont alors constitués d'une couche continue uniforme et dont la surface est laissée libre au niveau où les fils croissent.
(3) Croissance de la portion inférieure 22₁, 22₂ de chaque fil 20₁, 20₂ sur la hauteur H₂. Chaque fil 20₁, 20₂ croît depuis le sommet du plot de germination 16₁, 16₂ sous-jacent.
   Le procédé de croissance des fils 20₁, 20₂ peut être un procédé du type CVD, MOCVD, MBE, GSMBE, PAMBE, ALE, HVPE, ALD. En outre, des procédés électrochimiques peuvent être utilisés, par exemple, le dépôt en bain chimique (CBD, sigle anglais pour Chemical Bath Déposition), les procédés hydrothermiques, la pyrolyse d'aérosol liquide ou l'électrodépôt.
   A titre d'exemple, le procédé de croissance des fils peut comprendre l'injection dans un réacteur d'un précurseur d'un élément du groupe III et d'un précurseur d'un élément du groupe V. Des exemples de précurseurs d'éléments du groupe III sont le triméthylgallium (TMGa), le triéthylgallium (TEGa), le triméthylindium (TMIn) ou le triméthylaluminium (TMAl). Des exemples de précurseurs d'éléments du groupe V sont l'ammoniac (NH₃), le tertiarybutylphosphine (TBP), l'arsine (AsH₃), ou le diméthylhydrazine asymétrique (UDMH).
   Selon un mode de réalisation de l'invention, dans une première phase de croissance des fils du composé III-V, un précurseur d'un élément supplémentaire est ajouté en excès en plus des précurseurs du composé III-V. L'élément supplémentaire peut être le silicium (Si). Un exemple de précurseur du silicium est le silane (SiH₄).
   A titre d'exemple, dans le cas où la portion inférieure 22₁, 22₂ est en GaN fortement dopée de type N, un procédé du type MOCVD peut être mis en oeuvre par injection dans un réacteur MOCVD, de type douchette, d'un gaz précurseur du gallium, par exemple le triméthylgallium (TMGa) et d'un gaz précurseur de l'azote, par exemple l'ammoniac (NH₃). A titre d'exemple, on peut utiliser un réacteur MOCVD 3x2", de type douchette, commercialisé par la société AIXTRON. Un rapport de flux moléculaires entre le triméthylgallium et l'ammoniac dans la gamme 5-200, de préférence dans la gamme 10-100, permet de favoriser la croissance de fils. A titre d'exemple, un gaz porteur qui assure la diffusion des organométalliques jusque dans le réacteur vient se charger en organométalliques dans un bulleur de TMGa. Celui-ci est réglé selon les conditions standard de fonctionnement. Un flux de 60 sccm (centimètres cubes standard par minute) est, par exemple choisi pour le TMGa, tandis qu'un flux de 300 sccm est utilisé pour le NH₃ (bouteille standard de NH₃). On utilise une pression d'environ 800 mbar (800 hPa). Le mélange gazeux comprend, en outre, l'injection de silane dans le réacteur MOCVD, matériau précurseur du silicium. Le silane peut être dilué dans de l'hydrogène à 1000 ppm et l'on apporte un flux de 20 sccm. La température dans le réacteur est, par exemple, comprise entre 950°C et 1100°C, de préférence entre 990°C et 1060°C. Pour transporter les espèces de la sortie des bulleurs aux deux plénums du réacteur, on utilise un flux de gaz porteur, par exemple du N₂, de 2000 sccm réparti dans les deux plénums. Les flux de gaz indiqués précédemment sont donnés à titre indicatif et sont à adapter en fonction de la taille et des spécificités du réacteur.
   La présence de silane parmi les gaz précurseurs entraîne l'incorporation de silicium au sein du composé GaN. On obtient ainsi une portion inférieure 22₁, 22₂ dopée de type N. En outre, ceci se traduit par la formation d'une couche de nitrure de silicium, non représentée, qui recouvre le pourtour de la portion 22₁, 22₂ de hauteur H₂, à l'exception du sommet au fur et à mesure de la croissance de la portion 22₁, 22₂.
(4) Croissance de la portion supérieure 24₁, 24₂ de hauteur H₃ de chaque fil 20₁, 20₂ sur le sommet de la portion inférieure 22₁, 22₂. Pour la croissance de la portion supérieure 24₁, 24₂, les conditions de fonctionnement du réacteur MOCVD décrites précédemment sont, à titre d'exemple, maintenues à l'exception du fait que le flux de silane dans le réacteur est réduit, par exemple d'un facteur supérieur ou égal à 10, ou arrêté. Même lorsque le flux de silane est arrêté, la portion supérieure 24₁, 24₂ peut être dopée de type N en raison de la diffusion dans cette portion active de dopants provenant des portions passivées adjacentes ou en raison du dopage résiduel du GaN.
(5) Formation par épitaxie, pour chaque fil 20₁, 20₂, des couches composant la coque 28₁, 28₂. Compte tenu de la présence de la couche de nitrure de silicium recouvrant le pourtour de la portion inférieure 22₁, 22₂, le dépôt des couches composant la coque 28₁, 28₂ ne se produit que sur la portion supérieure 24₁, 24₂ du fil 20₁, 20₂.
(6) Formation de la couche isolante 26, par exemple par dépôt conforme d'une couche isolante sur la totalité de la structure obtenue à l'étape (5) et gravure de cette couche pour exposer la coque 28₁, 28₂ de chaque fil 20₁, 20₂. Dans le mode de réalisation décrit précédemment, la couche isolante 26 ne recouvre pas la coque 28₁, 28₂. A titre de variante, la couche isolante 26 peut recouvrir une partie de coque 28₁, 28₂. En outre, la couche isolante 26 peut être réalisée avant la formation de la coque 28₁, 28₂.
(7) Formation de chaque électrode 30₁, 30₂, par exemple par dépôt conforme et gravure.
(8) Formation de chaque couche conductrice 32₁, 32₂ par exemple par dépôt physique en phase vapeur (PVD, acronyme anglais pour Physical Vapor Déposition) sur l'ensemble de la structure obtenue à l'étape (7) et gravure de cette couche pour exposer chaque fil 20₁, 20₂.

Dans le mode de réalisation décrit précédemment, la couche isolante 26 recouvre la totalité du pourtour de la portion inférieure 22₁, 22₂ de chaque fil 20₁, 20₂. A titre de variante, une partie de la portion inférieure 22₁, 22₂, voire la totalité de portion inférieure 22₁, 22₂, peut ne pas être recouverte par la couche isolante 26. La couche 26 peut ne pas recouvrir la portion inférieure 22₁, 22₂ de chaque fil 20₁, 20₂. Dans ce cas, la coque 28₁, 28₂ peut recouvrir chaque fil 20 sur une hauteur supérieure à H₃, voire sur la hauteur H₁.

Dans le mode de réalisation décrit précédemment, la couche isolante 26 ne recouvre pas le pourtour de la portion supérieure 24₁, 24₂ de chaque fil 20₁, 20₂. A titre de variante, la couche isolante 26 peut recouvrir une partie de la portion supérieure 24₁, 24₂ de chaque fil 20₁, 20₂.

Selon une autre variante, la couche isolante 26 peut, pour chaque fil 20₁, 20₂, recouvrir partiellement la portion inférieure de la coque 28₁, 28₂.

Selon une variante du procédé de fabrication décrit précédemment, les couches composant la coque 28₁, 28₂ peuvent être formées avant la couche isolante 26 sur la totalité de chaque fil 20₁, 20₂ ou seulement sur une partie du fil 20₁, 20₂, par exemple la partie supérieure 24₁, 24₂.

La figure 11B représente la structure obtenue après les étapes suivantes :
- dépôt d'une couche d'encapsulation 34 sur la totalité de la plaque 10 ; et
- fixation de la poignée 36 sur la couche d'encapsulation 34.

Lorsque la couche d'encapsulation 34 est en un matériau inorganique, ce matériau peut être déposé par CVD basse température, notamment à une température inférieure à 300°C-400°C, par exemple par PECVD (acronyme anglais pour Plasma Enhanced Chemical Vapor Deposition).

Lorsque la couche d'encapsulation 34 est en un matériau organique, la couche d'encapsulation 34 peut être déposée par un procédé de dépôt à la tournette, par un procédé d'impression par jet ou par un procédé de sérigraphie. Un procédé de dispense par doseur temps/pression ou par doseur volumétrique est également possible en mode automatique sur des équipements programmables.

Selon un mode de réalisation, la poignée 36 est destinée à être conservée sur le dispositif optoélectronique final. La poignée 36 est alors en un matériau au moins en partie transparent. Selon un autre mode de réalisation, la poignée 36 est destinée à être retirée à une étape ultérieure du procédé de fabrication. Dans ce cas, la poignée 36 peut être réalisée en tout type de matériau compatible avec les étapes ultérieures du procédé de fabrication. Il peut s'agir de silicium ou tout substrat plan compatible avec les critères de planéité de la microélectronique.

La fixation de la poignée 36 à la couche d'encapsulation 34 peut être réalisée par tout moyen, par exemple par collage, en utilisant une couche de colle organique réticulable en température, non représentée, ou bien encore par collage moléculaire (collage direct) ou collage optique par colle durcie aux rayonnements ultra-violets. Lorsque la couche d'encapsulation 34 est en un matériau organique, ce matériau peut servir de colle pour la poignée 36.

Le procédé peut, en outre, comprendre une étape de formation d'une couche de luminophores, par exemple entre la couche d'encapsulation 34 et la poignée 36. La couche d'encapsulation 34 peut elle-même être en partie composée de luminophores.

La figure 11C représente la structure obtenue après une étape d'amincissement du substrat 10. Après amincissement, l'épaisseur du substrat 10 peut être comprise entre 20 µm et 200 µm, par exemple d'environ 30 µm. L'étape d'amincissement peut être réalisée par une ou plus d'une étape de meulage, de gravure, et/ou par des procédés de planarisation mécano-chimique ou CMP (acronyme anglais pour Chemical Mechanical Polishing). Le substrat 10 aminci comprend la face 12 opposée à la face 14. Les faces 12 et 14 sont de préférence parallèles.

La figure 11D représente la structure obtenue après les étapes suivantes :
- formation de la couche isolante 38, par exemple en oxyde de silicium (SiO₂) ou en nitrure et oxyde de silicium (SiON), sur la face arrière 12 du substrat 10. La couche isolante 38 est, par exemple, réalisée par dépôt conforme par PECVD. La couche isolante 38 a une épaisseur comprise entre 100 nm et 5000 nm, par exemple d'environ 1 µm ;
- gravure, pour chaque diode électroluminescente globale D₁, D₂, d'au moins une ouverture 100₁, 100₂ traversant la couche isolante 38, le substrat 10, la couche isolante 26 pour exposer la couche d'électrode 30₁, 30₂. De préférence, la couche d'électrode 30₁, 30₂ est également gravée pour exposer une portion de la couche métallique 32₁, 32₂. La gravure du substrat 10 peut être une gravure ionique réactive profonde (DRIE, acronyme anglais pour Deep Reactive Ion Etching). La gravure de la portion de la couche isolante 26 est aussi réalisée par gravure plasma avec la chimie adaptée à la couche isolante 26. En même temps, on peut graver la couche d'électrode 30₁, 30₂. A titre de variante, la couche 30₁, 30₂ peut être retirée des zones de formation des TSV avant l'étape de formation de la couche métallique 32₁, 32₂. L'ouverture 100₁, 100₂ peut avoir une section droite circulaire ou rectangulaire ;
- formation de la couche isolante 44₁, 44₂, par exemple en SiO₂ ou SiON sur la couche 38 et sur les parois internes de l'ouverture 100₁, 100₂. La couche isolante 44₁, 44₂ est, par exemple, réalisée par dépôt conforme par PECVD. La couche isolante 100₁, 100₂ a une épaisseur comprise entre 200 nm et 5000 nm, par exemple d'environ 3 µm. Dans le cas où des tranchées isolantes 56 sont prévues, comme cela est représenté aux figures 5 et 6, la couche isolante 44₁, 44₂ peut être formée en même temps que les tranchées 56 ;
- gravure de la couche isolante 44₁, 44₂ pour exposer la couche conductrice 32₁, 32₂ au fond de l'ouverture 100₁, 100₂. Il s'agit d'une gravure anisotrope ; et
- gravure d'au moins une ouverture 50₁, 50₂ dans la couche isolante 38, 44₁, 44₂ pour exposer une portion de la face 12 du substrat 10. Pour réaliser cette gravure, l'ouverture 100₁, 100₂ peut être temporairement bouchée, par exemple par une résine.

Les étapes suivantes permettant d'obtenir la structure représentée en figure 1 comprennent la formation des plots conducteurs 48₁, 48₂ dans les ouvertures 50₁, 50₂ et de la couche conductrice 42₁, 42₂ sur la couche isolante 44₁, 44₂, la couche conductrice 42₁, 42₂ recouvrant les parois internes de l'ouverture 100₁, 100₂ jusqu'à venir au contact de la portion métallique 32₁, 32₂ et s'étendant sur la face 12 autour de l'ouverture 100₁, 100₂ pour former le plot conducteur 46₁, 46₂.

Les plots conducteurs 46₁, 46₂, 48₁, 48₂ et la couche conductrice 42₁, 42₂ peuvent comprendre un empilement de deux ou plus de deux couches. Il s'agit par exemple de TiCu ou de TiAl. Cette couche peut être recouverte d'une autre couche métallique, par exemple de l'or, du cuivre ou des alliages eutectiques (Ni/Au ou Sn/Ag/Cu) en vue de la mise en oeuvre d'un procédé de brasage. Les plots conducteurs 46₁, 46₂, 48₁, 48₂ et la couche conductrice 42₁, 42₂ peuvent être formés, notamment dans le cas du cuivre, par dépôt électrochimique (ECD, acronyme anglais pour Electro-Chemical Deposition). L'épaisseur des plots conducteurs 46₁, 46₂, 48₁, 48₂ et la couche conductrice 42₁, 42₂ peut être comprise entre 1 µm et 10 µm, par exemple d'environ 5 µm.

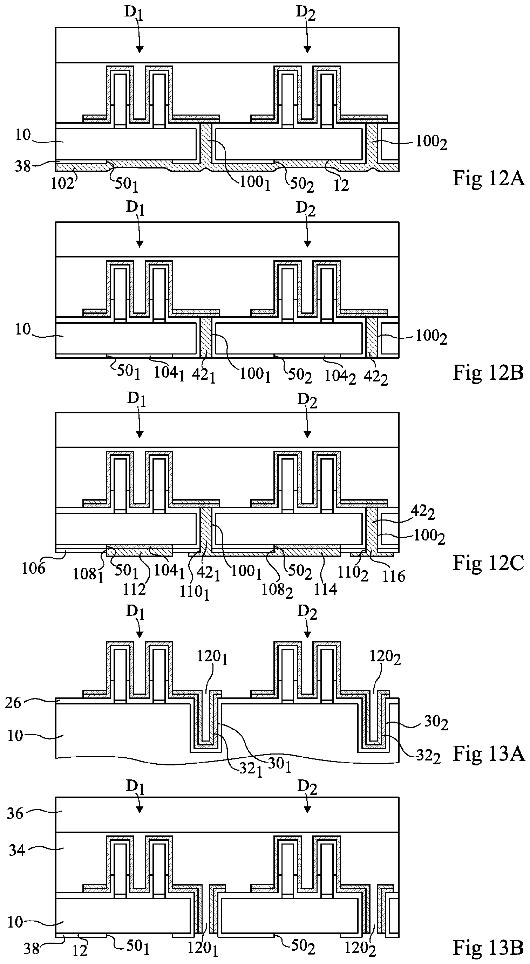

Les figures 12A à 12C sont des coupes, partielles et schématiques, de structures obtenues à des étapes successives d'un autre mode de réalisation d'un procédé de fabrication du dispositif optoélectronique 57 représenté en figure 7 et comprend l'ensemble des étapes décrites précédemment en relation avec les figures 11A à 11D.

La figure 12A représente la structure obtenue après un dépôt, du côté de la face arrière 12, d'une couche métallique 102 épaisse, par exemple du cuivre. Il peut s'agir d'un dépôt ECD. L'épaisseur de la couche 102 est, par exemple, de l'ordre de 10 µm. La couche métallique 102 est suffisamment épaisse pour remplir l'ouverture 100₁, 100₂.

La figure 12B représente la structure obtenue après une étape de polissage de la couche métallique 102 pour délimiter une portion métallique 104₁, 104₂ dans chaque ouverture 50₁, 50₂ et la portion conductrice 42₁, 42₂ dans l'ouverture 100₁, 100₂. L'étape de planarisation de la couche 102 peut être réalisée par CMP.

La figure 12C représente la structure obtenue après la mise en oeuvre des étapes suivantes :
- dépôt d'une couche isolante 106 sur la totalité de la face arrière du substrat 10 ;
- formation dans la couche isolante 106 d'une ouverture 108₁, 108₂ dans le prolongement de l'ouverture 50₁, 50₂ et d'une ouverture 110₁, 110₂ dans le prolongement de l'ouverture 100₁, 100₂ ; et
- formation d'une portion conductrice 112 dans l'ouverture 108₁ au contact de la portion métallique 104₁, formation d'une portion conductrice 114 au contact de la portion conductrice 42₁ au travers de l'ouverture 110₁ et de la portion conductrice 104₂ au travers de l'ouverture 108₂ et formation d'une portion conductrice 116 dans l'ouverture 110₂ au contact de la portion conductrice 42₂.

Les figures 13A et 13B sont des coupes, partielles et schématiques, de structures obtenues à des étapes successives d'un autre mode de réalisation d'un dispositif optoélectronique ayant une structure proche du dispositif optoélectronique 5 représenté en figure 1.

Les étapes initiales peuvent comprendre les étapes décrites précédemment en relation avec la figure 11A à la différence que, avant les étapes (5) à (8), une ouverture 120₁, 120₂ est formée dans le substrat 10 pour chaque diode électroluminescente globale D₁, D₂. L'ouverture 120₁, 120₂ peut être formée par une gravure du type DRIE. La profondeur de l'ouverture 120₁, 120₂ est strictement supérieure à l'épaisseur du substrat 10 après l'étape d'amincissement. A titre d'exemple, la profondeur de l'ouverture 120₁, 120₂ est comprise entre 10 µm et 200 µm, par exemple de l'ordre de 35 µm.

Lors de la mise en oeuvre des étapes (5) à (8), la couche isolante 26, l'électrode 30₁, 30₂ et la couche conductrice 32₁, 32₂ sont formées également dans l'ouverture 120₁, 120₂.

La figure 13B représente la structure obtenue après la réalisation des étapes suivantes :
- dépôt de la couche d'encapsulation 34 de façon analogue à ce qui a été décrit précédemment en relation avec la figure 11B. La couche d'encapsulation 34 pénètre partiellement ou totalement dans l'ouverture 120₁, 120₂ ;
- report de la poignée 36 de façon analogue à ce qui a été décrit précédemment en relation avec la figure 11B ;
- amincissement du substrat 10 de façon analogue à ce qui a été décrit précédemment en relation avec la figure 11C jusqu'à atteindre l'ouverture 120₁, 120₂ ;
- formation de la couche isolante 38 sur la face arrière 12 du substrat 10 en protégeant l'ouverture 120 ; et
- formation des ouvertures 50₁, 50₂ dans la couche isolante 38 pour exposer une portion du substrat 10.

Les étapes ultérieures du procédé peuvent être analogues à ce qui a été décrit précédemment.

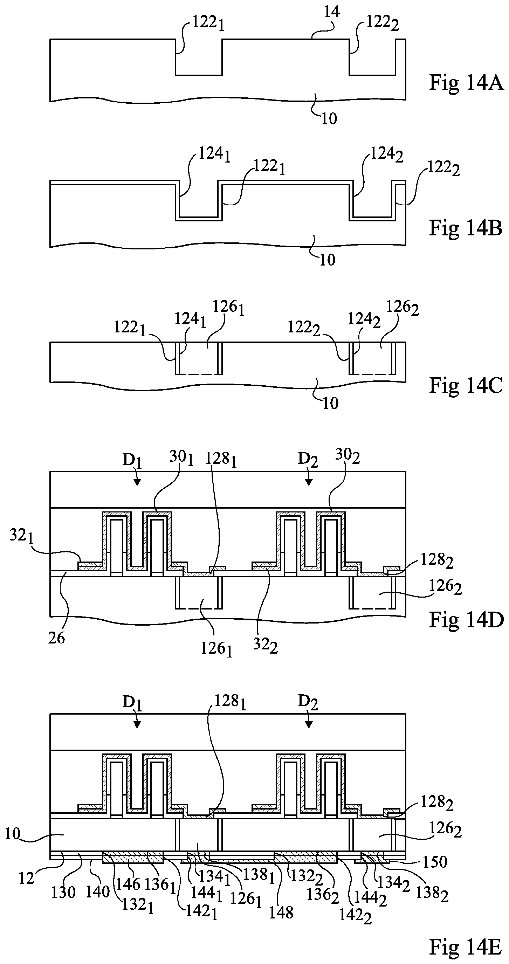

Les figures 14A à 14E sont des coupes, partielles et schématiques, de structures obtenues à des étapes successives d'un mode de réalisation d'un procédé de fabrication du dispositif optoélectronique 60 représenté en figure 8. Les figures 14A à 14C représentent des structures obtenues après la réalisation d'étapes avant l'étape (1) décrite précédemment en relation avec la figure 11A.

La figure 14A représente la structure obtenue après la gravure, pour chaque diode électroluminescente globale D₁, D₂, d'une ouverture 122₁, 122₂ dans le substrat 10. L'ouverture 122₁, 122₂ peut être formée par une gravure de type gravure ionique réactive, par exemple une gravure DRIE. La profondeur de l'ouverture 122₁, 122₂ est strictement supérieure à l'épaisseur visée du substrat 10 après l'étape d'amincissement. A titre d'exemple, la profondeur de l'ouverture 122₁, 122₂ est comprise entre 10 µm et 200 µm, par exemple environ 35 µm. La distance entre les parois latérales de l'ouverture 122₁, 122₂ est comprise entre 1 et 10 µm et par exemple 2 µm. La distance séparant l'ouverture 122₁ de la diode électroluminescente globale D₁ et l'ouverture 122₂ de la diode électroluminescente globale D₂ est comprise entre 100 µm et 3000 µm.

La figure 14B représente la structure obtenue après la formation d'une portion isolante 124₁, 124₂, par exemple en oxyde de silicium, sur les parois latérales de chaque ouverture 122₁, 122₂, par exemple par un procédé d'oxydation thermique. A cette étape, une portion isolante peut également se former au fond de l'ouverture 122₁, 122₂ et sur le reste du substrat 10. L'épaisseur de la portion isolante peut être comprise entre 100 nm et 3000 nm, par exemple environ 200 nm.

La figure 14C représente la structure obtenue après la mise en oeuvre des étapes suivantes :
- gravure anisotrope de la portion isolante au fond de l'ouverture 122₁, 122₂ et de la portion isolante recouvrant la face 14 du substrat 10 pour conserver les portions isolantes 124₁, 124₂ sur les flancs latéraux de l'ouverture 122₁, 122₂. A titre d'exemple, la gravure de la portion isolante recouvrant la face 14 du substrat 10 peut être omise. Dans ce cas, un masque réalisé par photolithographie peut être prévu pour protéger lesdites portions isolantes non gravées ;
- remplissage de chaque ouverture 122₁, 122₂ par un matériau de remplissage, par exemple du silicium polycristallin, non dopé, déposé par exemple par LPCVD. Le silicium polycristallin a, de façon avantageuse, un coefficient de dilatation thermique proche du silicium et permet ainsi de réduire les contraintes mécaniques durant les étapes réalisées à températures élevées décrites précédemment notamment en relation avec les étapes 11A à 11C ; et
- retrait de la couche du matériau de remplissage, par exemple un procédé de type CMP. Dans le cas où la gravure de la portion isolante recouvrant la face 14 du substrat 10 a été omise pendant la gravure anisotrope de la portion isolante au fond de l'ouverture 122₁, 122₂, ladite couche non gravée peut avantageusement être utilisée comme couche d'arrêt pendant le retrait de la couche du matériau de remplissage. Dans ce cas, le retrait de la couche du matériau de remplissage est suivi par une étape de gravure de la portion isolante recouvrant la face 14 du substrat 10.

Pour chaque diode électroluminescente D₁, D₂, une portion 126₁, 126₂ du matériau de remplissage est ainsi obtenue.

La figure 14D représente la structure obtenue après la mise en oeuvre d'étapes analogues à ce qui a été décrit précédemment en relation avec les figures 11A à 11C à la différence qu'il comprend, avant la formation de la couche conductrice 32₁, 32₂, une étape de gravure d'une ouverture 128₁, 128₂ dans la couche d'électrode 30₁, 30₂ et de la couche isolante 26 de sorte que la couche conductrice 32₁, 32₂ vienne au contact de la portion 126₁, 126₂.

La figure 14E représente la structure obtenue après la mise en oeuvre des étapes suivantes, de façon analogue à ce qui a été décrit précédemment en relation avec les figures 12A à 12C :
- amincissement du substrat 10 jusqu'à atteindre la portion conductrice 126₁, 126₂ ;
- formation d'une couche isolante 130 sur la face arrière 12 du substrat 10 ;
- formation, dans la couche isolante 130, pour chaque diode électroluminescente globale D₁, D₂, d'une ouverture 132₁, 132₂ pour exposer une portion de la face arrière 12 du substrat 10 et d'une ouverture 134₁, 134₂ pour exposer la portion conductrice 126₁, 126₂ ;
- formation d'un plot conducteur 136₁, 136₂ dans l'ouverture 132₁, 132₂ au contact du substrat 10 et d'un plot conducteur 138₁, 138₂ dans l'ouverture 134₁, 134₂ au contact de la portion conductrice 126₁, 126₂ ;
- dépôt d'une couche isolante 140 recouvrant la couche isolante 130 et les plots conducteurs 136₁, 136₂, 138₁, 138₂ ;
- formation dans la couche isolante 140 d'une ouverture 142₁, 142₂ dans le prolongement de l'ouverture 132₁, 132₂ et d'une ouverture 144₁, 144₂ dans le prolongement de l'ouverture 134₁, 134₂ ;
- formation d'une portion conductrice 146 dans l'ouverture 142₁ au contact de la portion métallique 136₁, formation d'une portion conductrice 148 au contact de la portion conductrice 138₁ au travers de l'ouverture 144₁ et de la portion conductrice 142₂ au travers de l'ouverture 142₁ et formation d'une portion conductrice 150 dans l'ouverture 144₂ au contact de la portion conductrice 42₂.

A titre de variante, la couche isolante 130 peut ne pas être présente et les plots conducteurs 136₁, 136₂, 138₁, 138₂ peuvent être formés directement sur le substrat 10.

Selon une autre variante, au lieu de délimiter une portion 126₁, 126₂ du substrat 10 par des tranchées isolées, le procédé peut comprendre les étapes suivantes à la place des étapes décrites précédemment en relation avec la figure 14A :
- gravure d'une ouverture dans le substrat 10 sensiblement aux dimensions de la portion 126₁, 126₂ ;
- formation d'une portion isolante, par exemple en oxyde de silicium, sur les parois latérales de l'ouverture, par exemple par un procédé d'oxydation thermique. A cette étape, une portion isolante peut également se former au fond de l'ouverture et sur le reste du substrat 10 ; et
- remplissage de l'ouverture par un matériau conducteur, par exemple silicium polycristallin dopé, du tungstène ou matériau métallique réfractaire qui supporte les températures présentes aux étapes ultérieures du procédé de fabrication.

Des modes de réalisation particuliers de la présente invention ont été décrits. Diverses variantes et modifications apparaîtront à l'homme de l'art. De plus, bien que, dans les modes de réalisation décrits précédemment, chaque fil 20₁, 20₂ comprenne une portion passivée 22₁, 22₂, à la base du fil en contact avec l'un des plots de germination 16₁, 16₂, cette portion passivée 22₁, 22₂ peut ne pas être présente.

En outre, bien que des modes de réalisation aient été décrits pour un dispositif optoélectronique pour lequel la coque 28₁, 28₂ recouvre le sommet du fil 20₁, 20₂ associé et une partie des flancs latéraux du fil 20₁, 20₂, la coque peut n'être prévue qu'au sommet du fil 20₁, 20₂.

## Revendications

1. Dispositif optoélectronique (5 ; 55 ; 57 ; 60) comprenant :
un substrat (10) semiconducteur dopé d'un premier type de conductivité, le substrat comprenant des première et deuxième faces opposées (12, 14) ;
un premier ensemble (D₁) de premières diodes électroluminescentes (DEL₁) reposant sur une première portion (54₁) du substrat et comprenant des premiers éléments semiconducteurs (20₁) filaires, coniques ou tronconiques ;
une première électrode (30₁), au moins partiellement transparente, recouvrant chaque première diode électroluminescente (DEL₁) ;
une première portion conductrice (42₁) isolée du substrat et traversant le substrat depuis la deuxième face jusqu'à au moins la première face et reliée à la première électrode ;
un deuxième ensemble (D₂) de deuxièmes diodes électroluminescentes (DEL₂) reposant sur une deuxième portion (54₂) du substrat et comprenant des deuxièmes éléments semiconducteurs (20₂) filaires, coniques ou tronconiques ;
une deuxième électrode (30₂), au moins partiellement transparente, recouvrant chaque deuxième diode électroluminescente (DEL₂) ;
une deuxième portion conductrice (42₂) isolée du substrat et traversant le substrat depuis la deuxième face jusqu'à au moins la première face et reliée à la deuxième électrode ; et
un premier élément conducteur (46₁, 51, 48₂), reliant du côté de la deuxième face, la première portion conductrice à la deuxième portion de substrat.

2. Dispositif optoélectronique selon la revendication 1, dans lequel la première portion (54₁) de substrat est isolée de la deuxième portion (54₂) de substrat par la première portion conductrice isolée (42₁).

3. Dispositif optoélectronique selon la revendication 2, comprenant des premier et deuxième bords latéraux opposés (52, 53) et dans lequel la première portion conductrice isolée (42₁) s'étend du premier bord au deuxième bord latéral.

4. Dispositif optoélectronique selon la revendication 2, dans lequel la première portion conductrice isolée (42₁) entoure la première portion de substrat (54₁).

5. Dispositif optoélectronique selon la revendication 1, comprenant une portion isolante (56), distincte de la première portion conductrice isolée (42₁), et isolant la première portion (54₁) de substrat de la deuxième portion (54₂) de substrat.

6. Dispositif optoélectronique selon la revendication 5, comprenant des premier et deuxième bords latéraux opposés (52, 53) et dans lequel la portion isolante (56) s'étend du premier bord au deuxième bord latéral.

7. Dispositif optoélectronique selon la revendication 5, dans lequel la première portion isolante (56) entoure la première portion de substrat (54₁).

8. Dispositif optoélectronique selon l'une quelconque des revendications 1 à 7, comprenant un premier plot conducteur (48₁) sur la deuxième face (12) au contact de la première portion (54₁) de substrat.

9. Dispositif optoélectronique selon l'une quelconque des revendications 1 à 8, dans lequel le substrat (10) est choisi parmi le groupe comprenant le silicium, le germanium, le carbure de silicium et les composés III-V.

10. Dispositif optoélectronique selon l'une quelconque des revendications 1 à 9, dans lequel la concentration de dopants du substrat (10) est comprise entre 5*10¹⁶ et 2*10²⁰ atomes/cm³.

11. Dispositif optoélectronique selon l'une quelconque des revendications 1 à 10, dans lequel les diodes électroluminescentes du premier ensemble (D₁, D₂) sont adaptées à émettre de la lumière à une première longueur d'onde et dans lequel les diodes électroluminescentes du deuxième ensemble (D₁, D₂) sont adaptées à émettre de la lumière à une seconde longueur d'onde différente de la première longueur d'onde.

12. Dispositif optoélectronique selon l'une quelconque des revendications 1 à 11, comprenant, en outre :
un troisième ensemble (D₃) de troisièmes diodes électroluminescentes reposant sur une troisième portion du substrat (54₃) et comprenant des troisièmes éléments semiconducteurs filaires, coniques ou tronconiques ;
une troisième électrode, au moins partiellement transparente, recouvrant chaque troisième diode électroluminescente ;
une troisième portion conductrice (40₃) isolée du substrat et traversant le substrat depuis la deuxième face (12) jusqu'à au moins la première face (14) et reliée à la troisième électrode ; et
un deuxième élément conducteur (46₂, 51₂, 48₃), reliant du côté de la deuxième face, la deuxième portion conductrice à la troisième portion de substrat.

13. Dispositif optoélectronique selon la revendication 12, dans lequel les diodes électroluminescentes du troisième ensemble (D₁, D₂, D₃) sont adaptées à émettre de la lumière à une troisième longueur d'onde différente des première et deuxième longueurs d'onde.

14. Dispositif optoélectronique selon la revendication 13, dans lequel les surfaces des premier, deuxième et troisième ensembles (D₁, D₂, D₃) sont choisies pour que la composition des lumières aux première, deuxième et troisième longueurs d'onde émises corresponde à une lumière émise blanche.

15. Dispositif optoélectronique selon la revendication 13 ou 14, dans lequel l'une de la première, deuxième ou troisième longueur d'onde correspond à une lumière bleue, une autre de la première, deuxième ou troisième longueur d'onde correspond à une lumière verte et une autre de la première, deuxième ou troisième longueur d'onde correspond à une lumière rouge.

16. Dispositif optoélectronique selon l'une quelconque des revendications 1 à 15, comprenant de quatre à plus de cent ensembles de diodes électroluminescentes connectés en série par des portions conductrices isolées du substrat et traversant le substrat depuis la deuxième face jusqu'à au moins la première face.

17. Procédé de fabrication d'un dispositif optoélectronique (5 ; 55 ; 57 ; 60) comprenant les étapes suivantes :
(a) prévoir un substrat (10) dopé d'un premier type de conductivité, le substrat comportant une première face (14) ;
(b) former, sur la première face, un premier ensemble (D₁) de premières diodes électroluminescentes (DEL₁) reposant sur une première portion (54₁) du substrat et comprenant des premiers éléments semiconducteurs (20₁) filaires, coniques ou tronconiques et un deuxième ensemble (D₂) de deuxièmes diodes électroluminescentes (DEL₂) reposant sur une deuxième portion (54₂) du substrat et comprenant des deuxièmes éléments semiconducteurs (20₂) filaires, coniques ou tronconiques ;
(c) former une première électrode (30₁), au moins partiellement transparente, recouvrant chaque première diode électroluminescente (DEL₁) et une deuxième électrode (30₂), au moins partiellement transparente, recouvrant chaque deuxième diode électroluminescente (DEL₂) ;
(d) recouvrir la totalité de la première face d'une couche (34) encapsulant les premières et deuxièmes diodes électroluminescentes ;
(e) réduire l'épaisseur du substrat ;
(f) former une première portion conductrice (42₁) isolée du substrat et traversant le substrat depuis une deuxième face (12) du substrat, opposée à la première face, jusqu'à au moins la première face et reliée à la première électrode et une deuxième portion conductrice (42₂) isolée du substrat et traversant le substrat depuis la deuxième face jusqu'à au moins la première face et reliée à la deuxième électrode ; et
(g) former un élément conducteur (46₁, 51, 48₂), reliant du côté de la deuxième face, la première portion conductrice à la deuxième portion de substrat.

18. Procédé selon la revendication 17, dans lequel les étapes (a) à (g) sont successives.

19. Procédé selon la revendication 17, dans lequel l'étape (f) est réalisée avant l'étape (b).

20. Procédé selon la revendication 17, dans lequel l'étape (f) est réalisée entre les étapes (b) et (c).

21. Procédé selon la revendication 18, dans lequel l'étape (f) comprend successivement la gravure de premières ouvertures (100₁, 100₂) dans le substrat (10) depuis la deuxième face (12), la formation d'une couche isolante (44₁, 44₂) au moins sur les parois latérales des premières ouvertures, et la formation d'une couche conductrice (42₁, 42₂) recouvrant la couche isolante, ou le remplissage des premières ouvertures par un matériau conducteur.

22. Procédé selon la revendication 19 ou 20, dans lequel l'étape (f) comprend, avant l'étape (b) ou entre les étapes (b) et (c), la gravure de deuxièmes ouvertures (120₁, 120₂) dans le substrat depuis la première face (14) sur une partie de l'épaisseur du substrat, les deuxièmes ouvertures étant ouvertes sur la deuxième face (12) après l'étape d'amincissement du substrat (10).

23. Procédé selon la revendication 22, dans lequel la première électrode (30₁, 32₁) est, en outre, formée dans l'une des deuxièmes ouvertures (120₁) et la deuxième électrode (30₂, 32₂) est, en outre, formée dans une autre des deuxièmes ouvertures (120₁).

24. Procédé selon la revendication 22, comprenant, avant l'étape (b), la formation d'une portion isolante (124₁, 124₂) au moins sur les parois latérales des deuxièmes ouvertures (122₁, 122₂) et le remplissage des deuxièmes ouvertures d'un matériau de remplissage.

25. Procédé selon la revendication 24, dans lequel le matériau de remplissage est identique au matériau composant le substrat (10).

26. Procédé selon la revendication 24, dans lequel le matériau de remplissage est un matériau semiconducteur dopé in-situ.

## Patentansprüche

1. Optoelektronische Vorrichtung (5; 55; 57; 60), welche Folgendes aufweist:
ein dotiertes Halbleitersubstrat (10) mit einem ersten Leitfähigkeitstyp,
wobei das Substrat erste und zweite gegenüberliegende Oberflächen (12, 14) aufweist;
eine erste Anordnung (D₁), von ersten lichtemittierenden Dioden (DEL₁),
die von einem ersten Teil (54₁) des Substrates getragen werden und erste drahtförmige, konische oder kegelstumpfförmige Halbleiterelemente (20₁) aufweisen;
eine erste Elektrode (30₁), die zumindest teilweise transparent ist, welche jede erste lichtemittierende Diode (DEL₁) bedeckt;
einen ersten leitenden Teil (42₁), der von dem Substrat isoliert ist und das Substrat von der zweiten Oberfläche zu zumindest der ersten Oberfläche durchkreuzt und mit der ersten Elektrode verbunden ist;
eine zweite Anordnung (D₂) von zweiten lichtemittierenden Dioden (DEL₂), die durch einen zweiten Teil (54₂) des Substrates getragen werden und zweite drahtförmige, konische oder kegelstumpfförmige Halbleiterelemente (20₂) aufweisen;
eine zweite Elektrode (30₂), die zumindest teilweise transparent ist, welche jede zweite lichtemittierende Diode (DEL₂) bedeckt;
einen zweiten leitenden Teil (42₂), der von dem Substrat isoliert ist und das Substrat von der zweiten Oberfläche zu zumindest der ersten Oberfläche durchkreuzt und mit der zweiten Elektrode verbunden ist; und
ein erstes leitendes Element (46₁, 51, 48₂), welches auf der Seite der zweiten Oberfläche den ersten leitenden Teil mit dem zweiten Substratteil verbindet.

2. Optoelektronische Vorrichtung nach Anspruch 1, wobei der erste Substratteil (54₁) von dem zweiten Substratteil (54₂) durch den ersten isolierten leitenden Teil (42₁) isoliert ist.

3. Optoelektronische Vorrichtung nach Anspruch 2, die erste und zweite gegenüberliegende seitliche Kanten (52, 53) aufweist, und wobei der erste isolierte leitende Teil (42₁) sich von der ersten zur zweiten seitlichen Kante erstreckt.

4. Optoelektronische Vorrichtung nach Anspruch 2, wobei der erste isolierte leitende Teil (42₁) den ersten Substratteil (54₁) umgibt.

5. Optoelektronische Vorrichtung nach Anspruch 1, die einen isolierenden Teil (56) aufweist, der sich von dem ersten isolierten leitenden Teil (42₁) unterscheidet und den ersten Substratteil (54₁) von dem zweiten Substratteil (54₂) isoliert.

6. Optoelektronische Vorrichtung nach Anspruch 5, die erste und zweite gegenüberliegende seitliche Kanten (52, 53) aufweist, und wobei der isolierende Teil (56) sich von der ersten zu der zweiten seitlichen Kante erstreckt.

7. Optoelektronische Vorrichtung nach Anspruch 5, wobei der erste isolierende Teil (56) den ersten Substratteil (54₁) umgibt.

8. Optoelektronische Vorrichtung nach einem der Ansprüche 1 bis 7, die ein erstes leitendes Kissen (48₁) auf der zweiten Oberfläche (12) in Kontakt mit dem ersten Substratteil (54₁) aufweist.

9. Optoelektronische Vorrichtung nach einem der Ansprüche 1 bis 8, wobei das Substrat (10) aus der Gruppe ausgewählt ist, welche Silizium, Germanium, Siliziumkarbid und III-V-Verbindungen aufweist.

10. Optoelektronische Vorrichtung nach einem der Ansprüche 1 bis 9, wobei die Dotierungsmittelkonzentration des Substrates (10) im Bereich von 5 x 10¹⁶ bis 2 x 10²⁰ Atome/cm³ ist.

11. Optoelektronische Vorrichtung nach einem der Ansprüche 1 bis 10, wobei die lichtemittierenden Dioden der ersten Anordnung (D₁, D₂) fähig sind, Licht mit einer ersten Wellenlänge zu emittieren, und wobei die lichtemittierenden Dioden der zweiten Anordnung (D₁, D₂) fähig sind, Licht mit einer zweiten Wellenlänge zu emittieren, die anders ist als die erste Wellenlänge.

12. Optoelektronische Vorrichtung nach einem der Ansprüche 1 bis 11, die weiter Folgendes aufweist:
eine dritte Anordnung (D₃) von dritten lichtemittierenden Dioden, die von einem dritten Halbleiterteil des Substrates (54₃) getragen werden und dritte drahtförmige, konische oder kegelstumpfförmige Halbleiterelemente aufweisen;
eine dritte Elektrode, die zumindest teilweise transparent ist, welche jede dritte lichtemittierende Diode bedeckt;
einen dritten leitenden Teil (40₃), der von dem Substrat isoliert ist, und das Substrat von der zweiten Oberfläche (12) zu zumindest der ersten Oberfläche (14) durchkreuzt und mit der dritten Elektrode verbunden ist; und
ein zweites leitendes Element (46₂, 51₂, 48₃), welche auf der Seite der zweiten Oberfläche den zweiten leitenden Teil mit dem dritten Substratteil verbindet.

13. Optoelektronische Vorrichtung nach Anspruch 12, wobei die lichtemittierenden Dioden der dritten Anordnung (D₁, D₂, D₃) fähig sind, Licht mit einer dritten Wellenlänge zu emittieren, die sich von den ersten und zweiten Wellenlängen unterscheidet.

14. Optoelektronische Vorrichtung nach Anspruch 13, wobei die Oberflächen der ersten, zweiten und dritten Anordnungen (D₁, D₂, D₃) so ausgewählt sind, dass die Zusammensetzung des Lichtes bei den ersten, zweiten und dritten emittierten Wellenlängen einem emittierten weißen Licht entspricht.

15. Optoelektronische Vorrichtung nach Anspruch 13 oder 14, wobei eine der ersten, zweiten oder dritten Wellenlängen blauem Licht entspricht, wobei eine andere der ersten, zweiten oder dritten Wellenlängen grünem Licht entspricht, und wobei eine weitere der ersten, zweiten oder dritten Wellenlängen rotem Licht entspricht.

16. Optoelektronische Vorrichtung nach einem der Ansprüche 1 bis 15, welche von 4 bis mehr als 100 Anordnungen von lichtemittierenden Dioden aufweist, die in Reihe durch leitende Teile verbunden sind, die von dem Substrat isoliert sind und das Substrat von der zweiten Oberfläche zu zumindest der ersten Oberfläche durchkreuzen.

17. Verfahren zur Herstellung einer optoelektronische Vorrichtung (5; 55; 57; 60), welches folgende Schritte aufweist:
(a) Vorsehen eines dotierten Substrates (10) eines ersten Leitfähigkeitstyps, wobei das Substrat eine erste Oberfläche (14) aufweist;
(b) Formen auf der ersten Oberfläche einer ersten Anordnung (D₁) von ersten lichtemittierenden Dioden (DEL₁), die von einem ersten Teil (54₁) des Substrates getragen werden und erste drahtförmige, konische oder kegelstumpfförmige Halbleiterelemente (20₁) aufweisen, und einer zweiten Anordnung (D₂) von lichtemittierenden Dioden (DEL₂), die durch einen zweiten Teil (54₂) des Substrates getragen werden und zweite drahtförmige, konische oder kegelstumpfförmige Halbleiterelemente (20₂) aufweisen;
(c) Formen einer ersten Elektrode (30₁), die zumindest teilweise transparent ist, welche jede erste lichtemittierende Diode (DEL₁) bedeckt, und einer zweiten Elektrode (30₂), die zumindest teilweise transparent ist, welche jede zweite lichtemittierenden Diode (DEL₂) bedeckt;
(d) Bedecken der gesamten ersten Oberfläche mit einer Schicht (34), welche die ersten und zweiten lichtemittierenden Dioden umkapselt;
(e) Verringern der Dicke des Substrates;
(f) Formen eines ersten leitenden Teils (42₁), der von dem Substrat iso-liert ist und das Substrat von einer zweiten Oberfläche (12) des Substrates, die der ersten Oberfläche gegenüberliegt, zu zumindest der ersten Oberfläche durchkreuzt und mit der ersten Elektrode verbunden ist, und eines zweiten leitenden Teils (42₂), der von dem Substrat isoliert ist und das Substrat von der zweiten Oberfläche zu zumindest der ersten Oberfläche durchkreuzt und mit der zweiten Elektrode verbunden ist; und
(g) Formen eines leitenden Elementes (46₁, 51, 48₂), welches auf der Seite der zweiten Oberfläche den ersten leitenden Teil mit dem zweiten Substratteil verbindet.

18. Verfahren nach Anspruch 17, wobei die Schritte (a) bis (g) aufeinander folgen.

19. Verfahren nach Anspruch 17, wobei der Schritt (f) vor dem Schritt (b) ausgeführt wird.

20. Verfahren nach Anspruch 17, wobei der Schritt (f) zwischen den Schritten (b) und (c) ausgeführt wird.

21. Verfahren nach Anspruch 18, wobei der Schritt (f) aufeinanderfolgend aufweist, erste Öffnungen (100₁, 100₂) von der zweiten Oberfläche (12) in das Substrat (10) zu ätzen, eine isolierende Schicht (44₁, 44₂) zumindest an den seitlichen Wänden der ersten Öffnungen zu formen und eine leitende Schicht (42₁, 42₂) zu formen, welche die isolierende Schicht bedeckt, oder die ersten Öffnungen mit einem leitenden Material zu füllen.

22. Verfahren nach Anspruch 19 oder 20, wobei der Schritt (f) aufweist, vor dem Schritt (b) oder zwischen den Schritten (b) und (c) zweite Öffnungen (120₁, 120₂) von der ersten Oberfläche (14) über einen Teil der Dicke des Substrates in das Substrat zu ätzen, wobei die zweiten Öffnungen nach dem Schritt des Dünnermachens des Substrates (10) an der zweiten Oberfläche (12) offen sind.

23. Verfahren nach Anspruch 22, wobei die erste Elektrode (30₁, 32₁) weiter in einer der zweiten Öffnungen (120₁) geformt ist und wobei die zweite Elektrode (30₂, 32₂) weiter in einer anderen der zweiten Öffnungen (120₁) geformt ist.

24. Verfahren nach Anspruch 22, welches aufweist, vor dem Schritt (b) einen isolierenden Teil (124₁, 124₂) zumindest an den seitlichen Wänden der zweiten Öffnungen (122₁, 122₂) zu formen und die zweiten Öffnungen mit einem Füllmaterial zu füllen.

25. Verfahren nach Anspruch 24, wobei das Füllmaterial mit dem Material identisch ist, welches das Substrat (10) bildet.

26. Verfahren nach Anspruch 24, wobei das Füllmaterial ein in-situ dotiertes Halbleitermaterial ist.

## Claims

1. An optoelectronic device (5; 55; 57; 60) comprising:
a doped semiconductor substrate (10) of a first conductivity type, the substrate comprising first and second opposite surfaces (12, 14);
a first assembly (D₁) of first light-emitting diodes (DEL₁) supported by a first portion (54₁) of the substrate and comprising first wire-shaped, conical, or frustoconical semiconductor elements (20₁);
a first electrode (30₁), at least partially transparent, covering each first light-emitting diode (DEL₁);
a first conductive portion (42₁) insulated from the substrate and crossing the substrate from the second surface to at least the first surface and connected to the first electrode;
a second assembly (D₂) of second light-emitting diodes (DEL₂) supported by a second portion (54₂) of the substrate and comprising second wire-shaped, conical, or frustoconical semiconductor elements (20₂);
a second electrode (30₂), at least partially transparent, covering each second light-emitting diode (DEL₂);
a second conductive portion (42₂) insulated from the substrate and crossing the substrate from the second surface to at least the first surface and connected to the second electrode; and
a first conductive element (46₁, 51, 48₂), connecting on the second surface side the first conductive portion to the second substrate portion.

2. The optoelectronic device of claim 1, wherein the first substrate portion (54₁) is insulated from the second substrate portion (54₂) by the first insulated conductive portion (42₁).

3. The optoelectronic device of claim 2, comprising first and second opposite lateral edges (52, 53) and wherein the first insulated conductive portion (42₁) extends from the first to the second lateral edge.

4. The optoelectronic device of claim 2, wherein the first insulated conductive portion (42₁) surrounds the first substrate portion (54₁).

5. The optoelectronic device of claim 1, comprising an insulating portion (56), different from the first insulated conductive portion (42₁) and insulating the first substrate portion (54₁) from the second substrate portion (54₂).

6. The optoelectronic device of claim 5, comprising first and second opposite lateral edges (52, 53) and wherein the insulating portion (56) extends from the first to the second lateral edge.

7. The optoelectronic device of claim 5, wherein the first insulating portion (56) surrounds the first substrate portion (54₁).

8. The optoelectronic device of any of claims 1 to 7, comprising a first conductive pad (48₁) on the second surface (12) in contact with the first substrate portion (54₁).

9. The optoelectronic device of any of claims 1 to 8, wherein the substrate (10) is selected from the group comprising silicon, germanium, silicon carbide, and III-V compounds.

10. The optoelectronic device of any of claims 1 to 9, wherein the dopant concentration of the substrate (10) is in the range from 5*10¹⁶ to 2*10²⁰ atoms/cm³.

11. The optoelectronic device of any of claims 1 to 10, wherein the light-emitting diodes of the first assembly (D₁, D₂) are capable of emitting light at a first wavelength and wherein the light-emitting diodes of the second assembly (D₁, D₂) are capable of emitting light at a second wavelength different from the first wavelength.

12. The optoelectronic device of any of claims 1 to 11, further comprising:
a third assembly (D₃) of third light-emitting diodes supported by a third semiconductor portion of the substrate (54₃) and comprising third wire-shaped, conical, or frustoconical semiconductor elements;
a third electrode, at least partially transparent, covering each third light-emitting diode;
a third conductive portion (40₃) insulated from the substrate and crossing the substrate from the second surface (12) to at least the first surface (14) and connected to the third electrode; and
a second conductive element (46₂, 51₂, 48₃), connecting on the second surface side the second conductive portion to the third substrate portion.

13. The optoelectronic device of claim 12, wherein the light-emitting diodes of the third assembly (D₁, D₂, D₃) are capable of emitting light at a third wavelength different from the first and second wavelengths.

14. The optoelectronic device of claim 13, wherein the surfaces of the first, second, and third assemblies (D₁, D₂, D₃) are selected so that the composition of the light at the first, second, and third emitted wavelengths corresponds to an emitted white light.

15. The optoelectronic device of claim 13 or 14, wherein one of the first, second, or third wavelengths corresponds to blue light, another one of the first, second, or third wavelengths corresponds to green light, and another one of the first, second, or third wavelengths corresponds to red light.

16. The optoelectronic device of any of claims 1 to 15, comprising from four to more than one hundred assemblies of light-emitting diodes series-connected by conductive portions insulated from the substrate and crossing the substrate from the second surface to at least the first surface.

17. A method of manufacturing an optoelectronic device (5; 55; 57; 60) comprising the steps of:
(a) providing a doped substrate (10) of a first conductivity type, the substrate comprising a first surface (14);
(b) forming, on the first surface, a first assembly (D₁) of first light-emitting diodes (DEL₁) supported by a first portion (54₁) of the substrate and comprising first wire-shaped, conical, or frustoconical semiconductor elements (20₁) and a second assembly (D₂) of light-emitting diodes (DEL₂) supported by a second portion (54₂) of the substrate and comprising second wire-shaped, conical, or frustoconical semiconductor elements (20₂);
(c) forming a first electrode (30₁), at least partially transparent, covering each first light-emitting diode (DEL₁) and a second electrode (30₂), at least partially transparent, covering each second light-emitting diode (DEL₂);
(d) covering the entire first surface with a layer (34) encapsulating the first and second light-emitting diodes;
(e) decreasing the substrate thickness;
(f) forming a first conductive portion (42₁) insulated from the substrate and crossing the substrate from a second surface (12) of the substrate, opposite to the first surface, to at least the first surface and connected to the first electrode and a second conductive portion (42₂) insulated from the substrate and crossing the substrate from the second surface to at least the first surface and connected to the second electrode; and
(g) forming a conductive element (46₁, 51, 48₂), connecting on the second surface side the first conductive portion to the second substrate portion.

18. The method of claim 17, wherein steps (a) to (g) are successive.

19. The method of claim 17, wherein step (f) is carried out before step (b).

20. The method of claim 17, wherein step (f) is carried out between steps (b) and (c).

21. The method of claim 18, wherein step (f) successively comprises etching first openings (100₁, 100₂) in the substrate (10) from the second surface (12), forming an insulating layer (44₁, 44₂) at least on the lateral walls of the first openings, and forming a conductive layer (42₁, 42₂) covering the insulating layer, or filling the first openings with a conductive material.

22. The method of claim 19 or 20, wherein step (f) comprises, before step (b) or between steps (b) and (c), etching second openings (120₁, 120₂) in the substrate from the first surface (14) across part of the substrate thickness, the second openings being open on the second surface (12) after the step of thinning the substrate (10).

23. The method of claim 22, wherein the first electrode (30₁, 32₁) is further formed in one of the second openings (120₁) and the second electrode (30₂, 32₂) is further formed in another one of the second openings (120₁).

24. The method of claim 22, comprising, before step (b), forming an insulating portion (124₁, 124₂) at least on the lateral walls of the second openings (122₁, 122₂) and filling the second openings with a filling material.

25. The method of claim 24, wherein the filling material is identical to the material forming the substrate (10).

26. The method of claim 24, wherein the filling material is an in-situ doped semiconductor material.
